(19) Europäisches Patentamt

European Patent Office

Office européen des brevets

(11) **EP 1 225 696 A2**

(12) **EUROPEAN PATENT APPLICATION**

(43) Date of publication:
**24.07.2002 Bulletin 2002/30**

(51) Int Cl.$^7$: **H03H 19/00**

(21) Application number: **02000359.6**

(22) Date of filing: **04.01.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **12.01.2001 JP 2001005797**

(71) Applicant: **SHARP KABUSHIKI KAISHA Osaka 545-8522 (JP)**

(72) Inventor: **Azuma, Shin'ichiro Nara 639-0254 (JP)**

(74) Representative: **Müller - Hoffmann & Partner Patentanwälte,
Innere Wiener Strasse 17
81667 München (DE)**

(54) **Analog signal processor**

(57) In an analog signal processor, to automatically compensate for an offset voltage produced in an output signal of an analog signal processing circuit (2) including a switched capacitor circuit (2-n), an offset detecting circuit (4), which detects the offset voltage in the output terminal of the analog signal processing circuit (2), is connected to an output end of the analog signal processing circuit (2), whereas a subtraction circuit (5), subtracting the detected offset voltage from an analog signal to be processed in the analog signal processing circuit (2), is connected to either an input end of the analog signal processing circuit (2) or an internal wiring thereof. On this account, it is possible to provide an analog signal processor with high operational stability, in which signal skew due to signal saturation in an analog signal processing circuit can be reduced.

FIG. 1

**Description**

FIELD OF THE INVENTION

The present invention relates to an analog signal processor containing an offset compensation circuit including a switched capacitor circuit and an analog signal processing circuit that automatically compensates for an offset voltage generated in an output signal of the analog signal processing circuit, more particularly to the analog signal processor including an analog signal processing circuit made up of a combination of a continuous-time analog signal processing element circuit and a discrete-time analog signal processing element circuit including the switched capacitor circuit.

BACKGROUND OF THE INVENTION

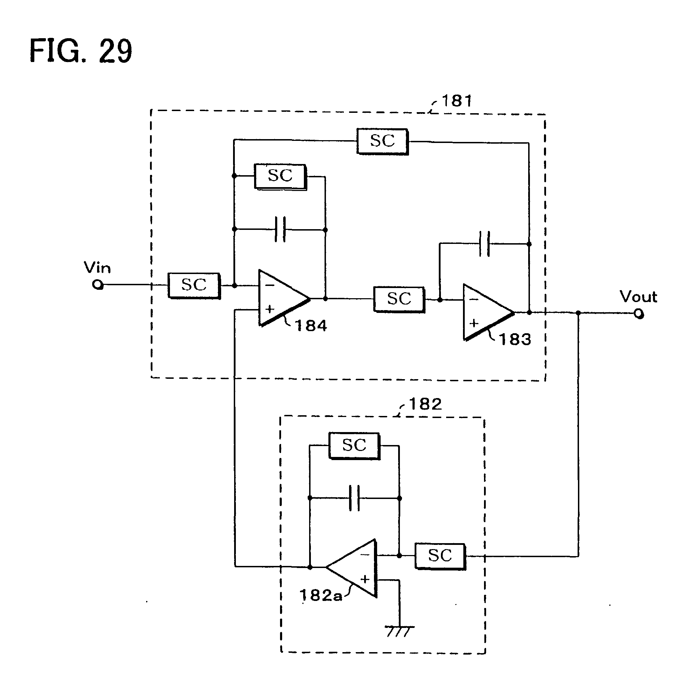

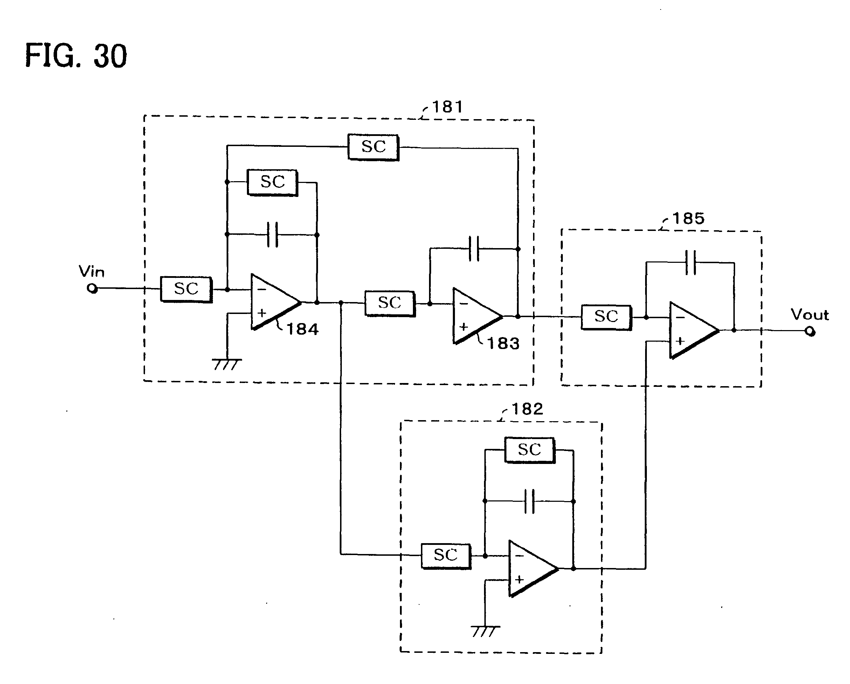

As an example of a conventionally known offset compensation circuit of an analog signal processing circuit including a switched capacitor circuit, there is a circuit that compensates for an output offset (offset voltage produced in an output signal) of a switched capacitor filter, described in Japanese Laid-Open Patent Application No. 61-196612 (Tokukaisho 61-196612; published on August 30, 1986) corresponding to Japanese Examined Patent Application No. 7-20049/1995 (Tokukouhei 7-20049; published on March 6, 1995). Figs. 29 and 30 show this arrangement. Incidentally, *SC* in figs. 29 and 30 indicates a switched capacitor equivalent resistance.

In the arrangement shown in fig. 29, an output of a switched capacitor filter 181 including two OP amps 183 and 184 (operational amplifier) is detected in an offset detector 182, and an output of the offset detector 182 is transmitted to a plus input terminal of the OP amp 184 of the switched capacitor filter 181. On this account, it is possible to reduce the output offset of the switched capacitor filter 181.

Meanwhile, in the arrangement shown in fig. 30, the output of the switched capacitor filter 181 including two OP amps 183 and 184 is input to the offset detector 182, and the output of the offset detector 182 and that of the switched capacitor filter 181 are merged (added) by a summing device 185. On this account, it is possible to reduce the offset.

However, while there is a bias voltage (optimal bias voltage) most suitable for the input of the operational amplifier (OP amp), there is also a center voltage for the output of the operational amplifier (OP amp). These voltages are not always identical in all operational amplifiers (OP amp). In the arrangement shown in fig. 29, the input terminal of the OP amp 184 directly receives an output of another OP amp 182a so that the voltage may be out of an appropriate range and make the OP amp unstable.

More specifically, when the output of the OP amp 182a is directly transmitted to the input terminal of the OP amp 184 as fig. 29 shows, a non-inverting input end of the OP amp 184 operates with reference to a center voltage of the output of the OP amp 182a. Thus provided that the center voltage of the output of the OP amp 182a is different from an optimal operating voltage of the input of the OP amp 184, the OP amp 184 may not operate with stability.

Furthermore, in the arrangement shown in fig. 30, a summing device 183 is provided in the latter stage of the switched capacitor filter 181 so that the offset voltage is compensated in the output end of the switched capacitor filter 181. On this account, it is not possible to avoid signal saturation inside the switched capacitor filter 181 owing to the offset voltage, and signal skew is apt to occur. That is, the arrangement shown in fig. 30 employs a method termed *feedforward* so that a detected offset voltage takes a path which is different from the signal path and the offset is removed by subtracting a voltage equal to the offset from the output part of the switched capacitor filter 181. Thus it is not possible to compensate for the offset when signal saturation occurs in the output end of the OP amp 183.

SUMMARY OF THE INVENTION

To solve the problems above, the present invention aims at providing an analog signal processor with high operational stability, in which signal skew due to signal saturation in an analog signal processing circuit can be reduced.

To achieve the aim above, an analog signal processor in accordance with the present invention includes:

an analog signal processing circuit including a switched capacitor circuit for processing an analog signal; and an offset compensation circuit for automatically compensating for an offset voltage produced in an output signal of the analog signal processing circuit, the offset compensation circuit includes: an offset detecting circuit connected to an output end of the analog signal processing circuit to detect the offset voltage in the output signal of the analog signal processing circuit; and a negative feedback path for feeding the offset voltage back to the analog signal processing circuit,
and the analog signal processor further includes:

an adding-subtracting circuit for adding or subtracting the offset voltage fed back via the negative feedback path to or from the analog signal processed in the analog signal processing circuit,

wherein the adding-subtracting circuit is connected to an input end of the analog signal processing circuit.

According to this arrangement, in contrast to a conventional arrangement shown in fig. 29 in which an output of an offset detector 182 is directly fed back into a switched capacitor filter 181 (analog signal processing circuit), an output of an operational amplifier is not directly transmitted to an input terminal of another operational amplifier, since an output signal of the offset detecting circuit is fed back to the input end of the analog signal processing circuit via the adding-subtracting circuit. On this account, an operating point of the operational amplifier can be within an appropriate range and the operation thereof can be highly stable.

Furthermore, according to the arrangement above, it is possible to compensate for the offset voltage in the input end of the analog signal processing circuit, since the adding-subtracting circuit is connected to the input end of the analog signal processing circuit. Thus signal saturation due to the offset voltage inside the analog signal processing circuit can be properly avoided, compared to a conventional arrangement shown in fig. 30 in which an offset voltage is compensated in an output end of the switched capacitor filter 181 (analog signal processing circuit). On this account, it is possible to implement the analog signal processor with low signal skew.

To achieve the aim above, an analog signal processor in accordance with the present invention includes:

an analog signal processing circuit including a switched capacitor circuit for processing an analog signal; and an offset compensation circuit for automatically compensating for an offset voltage produced in an output signal of the analog signal processing circuit, the offset compensation circuit including: an offset detecting circuit connected to an output end of the analog signal processing circuit to detect the offset voltage in the output signal of the analog the signal processing circuit; and a negative feedback path for feeding the offset voltage back to the analog signal processing circuit,

and the analog signal processor further includes:

an adding-subtracting circuit for adding or subtracting the offset voltage fed back via the negative feedback path to or from the analog signal processed in the analog signal processing circuit,

wherein the adding-subtracting circuit is provided on a line inside the analog signal processing circuit.

According to this arrangement, in contrast to a conventional arrangement shown in fig. 29 in which an output of an offset detector 182 is directly fed back into a switched capacitor filter 181 (analog signal processing circuit), an output of an operational amplifier is not directly transmitted to an input terminal of another operational amplifier, since an output signal of the offset detecting circuit is fed back into the analog signal processing circuit via the adding-subtracting circuit. On this account, an operating point of the operational amplifier can fall within an appropriate range and the operation thereof can be highly stable.

Furthermore, according to the arrangement above, it is possible to compensate for the offset voltage inside the analog signal processing circuit, since the adding-subtracting circuit is connected to the line inside the analog signal processing circuit. Thus signal saturation due to the offset voltage inside the analog signal processing circuit can be properly avoided, compared to a conventional arrangement shown in fig. 30 in which an offset voltage is compensated in an output end of the switched capacitor filter 181 (analog signal processing circuit). On this account, it is possible to implement the analog signal processor with low signal skew.

Incidentally, terms below used in the specification of this application have particular meanings as described below.

First of all, *switched capacitor circuit* is a kind of signal processing circuit for processing an input signal by sampling the same. The switched capacitor circuit is operated by a clock signal and samples an input signal so that the signal is processed in a time-discrete manner. Thus the switched capacitor circuit is a kind of time-discrete circuit. The switched capacitor circuit is often used as an analog signal processing circuit such as a sampling circuit, an amplifier, a filter, a digital/analog converter, and a peak detecting circuit. Moreover, *switched capacitor filter* is a filter implemented by the switched capacitor circuit, whereas *switched capacitor equivalent resistance* is a switched capacitor circuit equivalent to a resistance.

In the meantime, *analog signal processing element circuit* is a circuit dealing with all kinds of non-quantized analog signals, including not only a discrete-time circuit such as a switched capacitor circuit but also a continuous-time signal processing circuit. *Element circuit* is a general concept indicating a minimal element (functional block) of a circuit:

made up of several elements chosen from all sorts of elements (parts) that are able to constitute an electric circuit; and capable of offering a certain function such as an amplifier and a sampling circuit by itself,

such as a resistance, a capacitor, an inductor, an operational amplifier (OP amp), a switch, and a transistor. Thus *analog signal processing element circuit* means an element circuit for processing an analog signal. Also, *analog signal processing circuit* indicates entirety of a signal processing circuit made up of more than one analog signal processing element circuit.

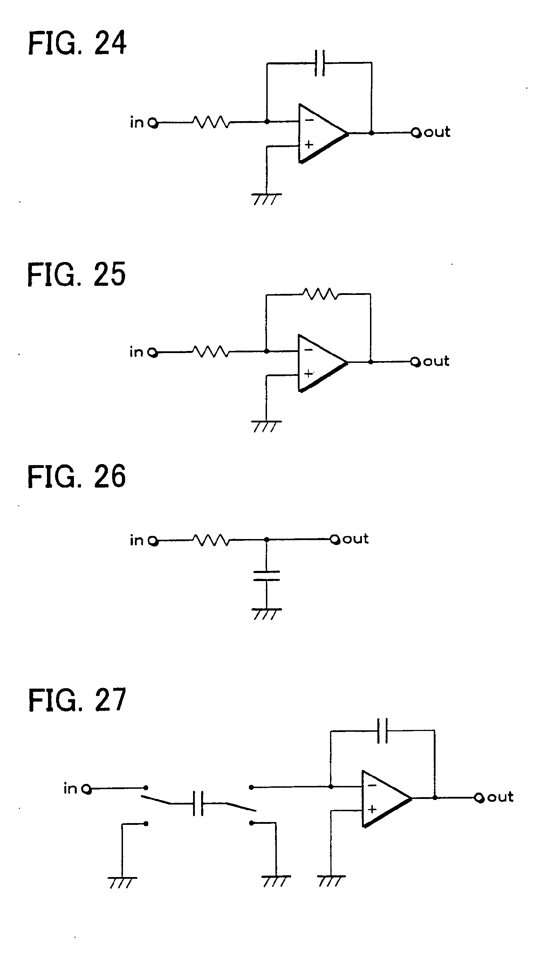

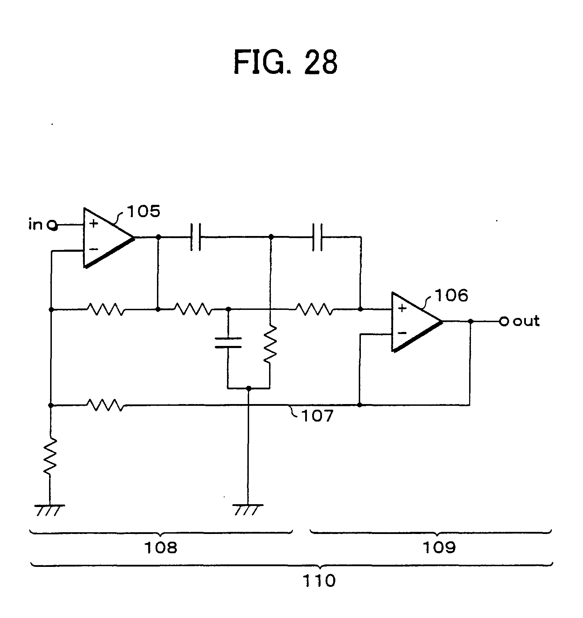

Figs. 24 to 28 show examples of analog signal processing element circuits. An analog signal processing element circuit shown in fig. 24 is an integrator circuit, an analog signal processing element circuit shown in fig. 25 is an amplifier, an analog signal processing element circuit shown in fig. 26 is an RC filter (passive), an analog signal processing element circuit shown in fig. 27 is a switched capacitor integrator circuit, and an analog signal processing element circuit shown in fig. 28 is a filter circuit. A circuit, including two operational amplifiers 105 and 106 and a feedback path 107 which is a path from an output end of one operational amplifier 105 to an input end of the other operational amplifier 106, is a single analog signal processing element circuit, as in the case of a filter circuit shown in fig. 28. This is because each operational amplifying circuit such as a circuit part 108 including the operational amplifier 105 and a circuit part 109 including the operational amplifier 106 do not have functions in themselves so that it is an entire circuit 110 including the feedback path 107 which has a certain function (in this case as a filter).

*Adding-subtracting circuit* indicates an adder circuit or a subtraction circuit. *Discrete-time circuit* is a signal processing circuit in which a signal is processed in a time-discrete manner. *Continuous-time circuit*, also known as time-continuous circuit, is a circuit that processes a signal without sampling the same, for instance, a sinusoidal wave remains as it is. The continuous-time circuit is opposite to the discrete-time circuit operating in time-discrete manner. An RC filter is one of the examples of the continuous-time circuit.

Incidentally, in an offset compensation circuit disclosed in conventional Japanese Laid-Open Patent Application No. 61-196612 (Tokukaisho 61-196612; published on August 30, 1986), the switched capacitor filter 181, which is a target of offset compensation, is made up of not two stages of analog signal processing element circuits but a single stage thereof. As described above, the analog signal processing element circuit is a functional block certainly having a particular function. Similarly with the filter circuit shown in fig. 28, the switched capacitor filter 181 is a circuit including two OP amps 183 and 184 and a feedback path which is a path from an output end of the one OP amp 183 to an input end of the other OP amp 184. Thus each of the circuit parts of the switched capacitor filter 181 including OP amps 183 and 184 do not have functions independently but operates as a part of the entire circuit including the feedback. On this account, the switched capacitor filter 181 is not two-staged circuit but a single analog signal processing element circuit en masse.

Therefore the conventional offset compensation circuit does not compensate for an offset of the entirety of an analog signal processing circuit made up of more than one analog signal processing element circuit. In other words, the conventional offset compensation circuit cannot compensate for the offset of the entirety of the analog signal processing circuit made up of more than one analog signal processing element circuit including a continuous-time analog signal processing element and a switched capacitor circuit. Thus an offset of each analog signal processing element circuit, especially that of each continuous-time analog signal processing element circuit has to be individually compensated in the conventional offset compensation circuit. On this account, the circuit is complicated and large in size, and requires high power consumption.

That is to say, for instance, when a continuous-time analog input signal is processed in a discrete-time filter such as a switched capacitor filter, it is practically necessary to remove an aliasing error. Thus to prevent the occurrence of this aliasing error, it is required that a band of an analog signal is limited in advance up to a frequency element fs/2 which is a half of the sampling frequency fs of the discrete-time filter of the analog signal, by a continuous-time filter provided in a stage before the discrete-time filter.

When the continuous-time filter is provided before the discrete-time filter as above, an offset is produced in the continuous-time filter as in the discrete-time filter so that it is necessary to compensate for the offset of the continuous-time filter provided in the stage before the discrete-time filter. In this case, the offset of the continuous-time filter may not be compensated even if the conventional offset compensation circuit is provided in the discrete-time filter.

That is, when the aforementioned element circuit has a gain (amplification factor is more than ×1), not only an analog signal but also an offset is amplified, and hence an offset of each element circuit has to be compensated individually. When only a switched capacitor filter which is a continuous-time filter has a gain and an offset produced in the switched capacitor filter is amplified, the offset can be removed (compensated) using the conventional offset compensation circuit. However, when a continuous-time filter having a gain is provided in a stage before or after the switched capacitor filter, the offset of the continuous-time filter cannot be removed unless a function of the offset compensation is attached to the continuous-time filter itself. In other words, in the conventional technique, it is impossible to compensate for the offset of the switched capacitor performing the time-discrete process simultaneously with that of the continuous-time filter, and hence the offset compensation must be individually done for each of them. Moreover, the offset amplified in the continuous-time filter makes the center of an output voltage level of the continuous-time filter be tilted toward either plus or minus side so that the center of an output voltage level of an operational amplifier in the filter is tilted toward either plus or minus side. On this account, a range (signal range) of a voltage level of an output signal narrows since an actual operational amplifier has a limit in a range of transmittable signal so that the signal on either plus or minus side is saturated, and consequently a signal skew occurs therein. In other words, it is not possible to acquire the operational amplifier having good signal processing characteristics.

An analog signal processed in a switched capacitor digital/analog converter is discrete. Thus a continuous-time filter performing a smoothing process through limiting a band may be provided with respect to the digital/analog-converted analog signal, in a stage after the switched capacitor digital/analog converter. In this case it is necessary to compensate for not only an offset of the switched capacitor digital/analog convertor but also that of the continuous-time filter.

To solve the problems above, the present invention alternatively aims at providing an analog signal processor with low signal skew, in which offsets of an analog signal processing circuit made up of a series of analog signal processing element circuits including a switched capacitor circuit are automatically compensated altogether and the size and power consumption of the circuit are reduced.

To achieve the aim above, the analog signal processing circuit is preferably made up of more than one analog signal processing element circuit.

According to this arrangement, in the analog signal processing circuit including the switched capacitor circuit, it is possible to compensate for all offsets of the more than one analog signal processing element circuit altogether by a single offset detecting circuit, since negative feedback is applied to the entirety of the analog signal processing circuit made up of the more than one analog signal processing element circuit including the switched capacitor circuit. Particularly, it is possible to prevent significant increase in the size and power consumption of the circuit, since it is not necessary to provide the offset compensation circuit in each of the analog signal processing element circuit in the analog signal processing circuit.

Moreover, it is preferable that the analog signal processor, in which the adding-subtracting circuit is provided on the wire inside the analog signal processing circuit, is further arranged so that the analog signal processing circuit is made up of connected analog signal processing element circuits, the adding-subtracting circuit is provided on the wire connecting the analog signal processing element circuits, and the offset voltage fed back via the negative feedback path is added or subtracted to/from an output signal of the analog signal processing element circuit provided immediately before the adding-subtracting circuit.

According to this arrangement, signal saturation due to the offset voltage in the analog signal processing element circuit provided in a stage after the adding-subtracting circuit can be avoided more properly, since it is possible to compensate for the offset voltage in an input end of the analog signal processing element circuit provided in the stage after the adding-subtracting circuit. Thus it is possible to implement the analog signal processor with lower signal skew.

In the analog signal processors of the arrangements above, it is preferable that the offset detecting circuit also includes a discrete-time circuit, more preferably a switched capacitor circuit, since the analog signal processing circuit includes a switched capacitor circuit which is a discrete-time circuit.

Moreover, the adding-subtracting circuit may have a gain with respect to the offset voltage, i.e. may have an amplification factor more than ×1 with respect to the offset voltage.

In the analog signal processor in accordance with the present invention, to compensate for the offset adequately, it is required that the offset voltage of the output signal of the analog signal processing circuit is negatively fed back to the input end of the analog signal processor or inside thereof, after the offset voltage is adequately amplified. As described above, when the adding-subtracting circuit has the amplification factor more than ×1 at least with respect to the offset voltage, the signal amplification necessary to the offset compensation can be jointly done by the offset detecting circuit and the adding-subtracting circuit. On this account, it is possible to prevent saturation of the output of the offset detecting circuit, and establish a stable feedback loop.

Moreover, the offset detecting circuit is preferably a switched capacitor integrator circuit including a switched capacitor equivalent resistance to which the output signal of the analog signal processing circuit is supplied, a first operational amplifier connected to the output end of the switched capacitor equivalent resistance, and a capacitor connected to input and output ends of the first operational amplifier.

In the analog signal processor in accordance with the present invention, it is necessary to make an input impedance of the offset detecting circuit adequately high so as to lighten the load, to compensate for the offset adequately. In the offset detecting circuit arranged as above, the output signal of the analog signal processing circuit is transmitted to the first operational amplifier via the switched capacitor equivalent resistance so that the impedance can be elevated to a higher level, compared to an offset detecting circuit using a resistance. As a result, designing the analog signal processing circuit becomes easier.

Moreover, it is preferable that the analog signal processor in accordance with the present invention further includes:

first clock signal providing means for providing a first control clock signal for controlling the switched capacitor circuit to the switched capacitor circuit; and
second clock signal providing means for providing a second control clock signal for controlling the switched capacitor integrator circuit to the switched capacitor integrator circuit,

wherein the second control clock signal is in sync with the first control clock signal.

According to this arrangement, since a sampling operation of the switched capacitor integrator circuit of the offset compensation circuit and the same of the switched capacitor circuit of the analog signal processing circuit are in sync with each other so that the timings of these samplings are in sync with each other. On this account, signals can be processed without any signal sampling error. Also, an output signal of the analog signal processing circuit, in which the output above is settled, can be captured by the switched capacitor integrator circuit of the offset compensation circuit so that it is possible to precisely process signals. Meanwhile, the output signal of the offset compensation circuit whose output is settled can be captured by the analog signal processing circuit too. On this account, these two do not capture an unsettled output which is not original signal elements of those two so that it is possible to reduce an occurrence of the signal skew. In other words, synchronization of the whole circuit makes it possible to transmit an accurate signal in each point of the circuit.

Moreover, the analog signal processor in accordance with the present invention may further include:

first clock signal providing means for providing a first control clock signal for controlling the switched capacitor circuit to the switched capacitor circuit; and
second clock signal providing means for providing a second control clock signal for controlling the switched capacitor integrator circuit to the switched capacitor integrator circuit,

wherein the second clock signal providing means provides a clock signal (clock signal having a frequency which is a submultiple of the frequency of the first control clock signal) produced by dividing the first control clock signal to the switched capacitor integrator circuit, as the second control clock signal.

According to this arrangement, it is possible to further lower the passband of the offset detecting circuit necessary for the offset compensation, by providing a clock signal produced by dividing the first clock signal, for controlling the switched capacitor circuit in the analog signal processing circuit, to the switched capacitor integrator circuit, as the second control clock signal for controlling the switched capacitor integrator circuit. On this account, it is unnecessary to use a large capacitor to ensure the band required for the offset compensation circuit so that it is unnecesary to keep a large area for the capacitor. As a result, it is possible to restrain the increase in power consumption by restraining the increase in the load due to the increased capacitance, as well as the increase in the area required for the circuit. Moreover, it is also possible to broaden the passband of the analog signal processing circuit by lowering the passband of the offset compensation circuit.

Moreover, the analog signal processor in accordance with the present invention may further include:

first clock signal providing means for providing a first control clock signal for controlling the switched capacitor circuit to the switched capacitor circuit; and
second clock signal providing means for providing a second control clock signal for controlling the switched capacitor integrator circuit to the switched capacitor integrator circuit,

wherein the second clock signal providing means provides a clock signal, having a frequency which is an integral multiple of the frequency of the first control clock, to the switched capacitor integrator circuit, as the second control clock signal.

According to this arrangement, it is possible to reduce the time required for the offset compensation by setting the gain of the offset compensation circuit higher.

Furthermore, it is preferable that the adding-subtracting circuit includes:

a second operational multiplier including a plus input terminal and a minus input terminal; and
an input element made up of a resistance element or a switched capacitor equivalent resistance,

and at least one of the plus and minus input terminals of the operational amplifier is connected to an output end of the offset detecting circuit via the input element.

According to this arrangement, the adding-subtracting circuit for inputting an offset signal (output signal of the offset detecting circuit) to the analog signal processing circuit includes the input element made up of the resistance element or the switched capacitor equivalent resistance so that it is possible to make the load of the offset compensation circuit be a capacitive load. On this account, it is possible to restrain the increase in power consumption of the operational amplifier in the offset compensation circuit.

Moreover, it is preferable that the input element is made up of the switched capacitor equivalent resistance.
When the switched capacitor equivalent resistance is used for both the offset detecting circuit and the adding-subtracting circuit, it is possible to restrain the increase in power consumption of the entire analog signal processing circuit and the operational amplifier in the offset detecting circuit due to a high impedance of each of these two.
Moreover, it is preferable that the adding-subtracting circuit includes the operational amplifier and at least one element selected from the group consisting of a resistance, a switched capacitor equivalent resistance, and a capacitor.
Moreover, it is preferable that the adding-subtracting circuit includes:

the operational amplifier;
a first input element: connected to an input terminal of the operational amplifier; and to which an analog signal to be processed is transmitted;
a second input element connected to the output end of the offset detecting circuit and the input terminal of the operational amplifier; and
a feedback element connected to the input terminal of the second operational amplifier and the output terminal thereof,

and the first input element, the second input element, and the feedback element are at least one element selected from the group consisting of a resistance, a switched capacitor equivalent resistance, and a capacitor. In this arrangement, it is possible to set the gain of the adding-subtracting circuit by determining a resistance ratio or a capacity ratio between the elements.
Moreover, it is preferable that a gain of the offset detecting circuit is huge with respect to the offset voltage, i.e. an amplification factor of the circuit is much more than $\times 1$ with respect to the offset voltage. According to this arrangement, it is possible to restrict the band required for the offset compensation and preserve the stability of the analog signal processor, when the offset detecting circuit has a huge gain with respect to the offset voltage. A manufacturer of the analog signal processor can set the gain of the offset detecting circuit arbitrary, by determining a ratio of the capacity of the switched capacitor equivalent resistance to that of the capacitor. The manufacturer can determine the length of time between when the device is put into operation and when the compensation of the offset voltage is finished, by controlling the gain of the offset detecting circuit.
For a fuller understanding of the nature and advantages of the invention, reference should be made to the ensuing detailed description taken in conjunction with the accompanying drawings.

BRIEF DESCRIPTION OF THE DRAWINGS

Fig. 1 is a block diagram showing an overall arrangement of an analog signal processing circuit with an offset compensation circuit, as an embodiment of an analog signal processor of the present invention.
Fig. 2 is a circuit diagram showing an example of a continuous-time filter that can be used as an analog signal processing element circuit included in the analog signal processing circuit with the offset compensation circuit.

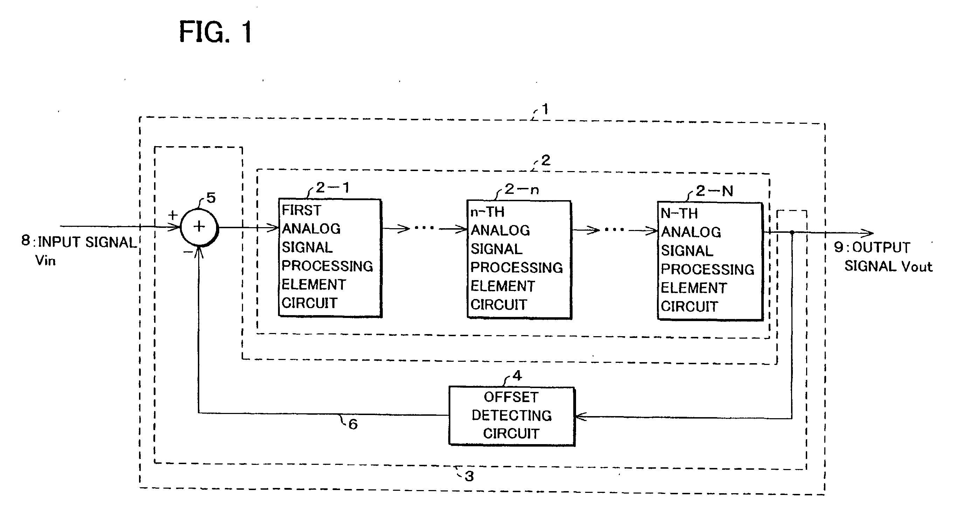

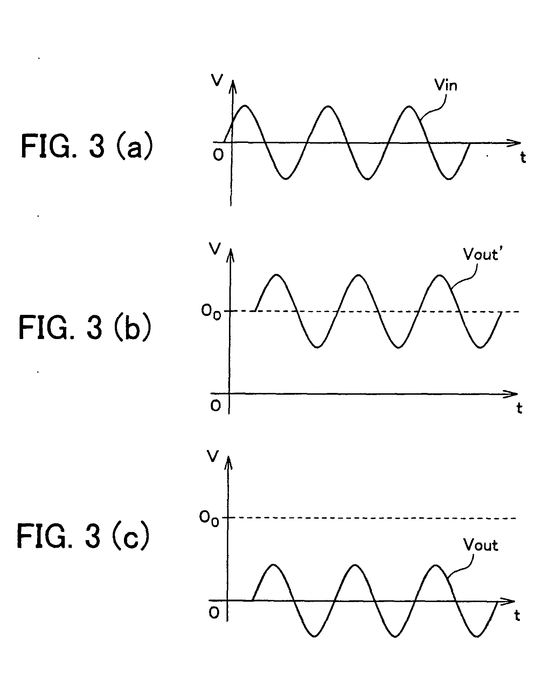

Figs. 3(a) to 3(c) are views describing a relationship between a voltage level of an input signal and that of an output signal, when an analog signal is transmitted to each of: the analog signal processing circuit with the offset compensation circuit; and an analog signal processing circuit (conventional analog signal processor) equivalent to the analog signal processing circuit shown in fig. 1 without the offset compensation circuit. Fig. 3 (a) indicates a voltage level of an input signal, fig. 3(b) indicates a voltage level of an output signal of the analog signal processing circuit with offset compensation circuit, and fig. 3(c) indicates a voltage level of an output signal of the conventional analog signal processor.
Fig. 4 explains a principle of removing an offset voltage by an offset compensation circuit. Fig. 4(a) indicates frequency response characteristics of the offset detecting circuit, fig. 4(b) indicates frequency distribution of an input signal, and fig. 4(c) indicates frequency dependance of a gain of the analog signal processing circuit with the offset compensation circuit shown in fig. 1.
Fig. 5 indicates a discrete-time signal that can be transmitted from the analog signal processing circuit with offset detecting circuit shown in fig. 1.
Fig, 6 is a block diagram showing an example of an offset detecting circuit used in the present invention.
Fig. 7 is a circuit diagram showing an example of a switched capacitor equivalent resistance used in the offset detecting circuit.
Fig. 8 is a circuit diagram showing another example of a switched capacitor equivalent resistance used in the offset detecting circuit.
Fig. 9 is a circuit diagram showing a further example of a switched capacitor equivalent resistance used in the offset detecting circuit.

Fig. 10 is a circuit diagram showing yet another example of a switched capacitor equivalent resistance used in the offset detecting circuit.

Figs. 11(a) and 11(b) are waveform diagrams showing waveforms of clock signals for controlling the switched capacitor equivalent resistance.

Figs. 12(a) and 12(b) describe a process of offset voltage compensation in the analog signal processing circuit with the offset compensation circuit. Fig. 12(a) indicates variations of an output signal and an output offset component with respect to time, whereas fig. 12(b) indicates variations of an output signal of an offset detecting circuit with respect to time.

Fig. 13 is a block diagram showing an example of a full-differential switched capacitor integrator circuit that can be used as an offset detecting circuit.

Fig. 14 is a block diagram showing a differential input type subtraction circuit which is an example of an adding-subtracting circuit that can be used in the analog signal processing circuit with the offset compensation circuit.

Fig. 15 is a block diagram showing an inversion adder circuit which is another example of an adding-subtracting circuit that can be used in the analog signal processing circuit with the offset compensation circuit.

Fig. 16 is a block diagram showing an example of an arrangement of the analog signal processing circuit with the offset compensation circuit adopting the inversion adder circuit shown in fig. 15.

Fig. 17 is a view showing: a signal in each stage of the analog signal processing circuit when a gain is huge; and a range in each stage within which the signal is not saturated.

Fig. 18 is a view showing: a signal in each stage of the analog signal processing circuit when an offset is huge; and a range in each stage within which the signal is not saturated.

Fig. 19 is a view showing: a signal in each stage of the analog signal processing circuit when an inverted offset is transmitted in the offset detecting circuit; and a range in each stage within which the signal is not saturated.

Fig. 20 is a block diagram showing an overall arrangement of an analog signal processing circuit with an offset compensation circuit, as another embodiment of an analog signal processor of the present invention.

Fig. 21 indicates a relationship between a control clock signal for controlling each circuit included in an analog signal processing circuit with an offset compensation circuit and an output signal of each circuit with respect to time.

Fig. 22 is a block diagram showing an overall arrangement of an analog signal processing circuit with an offset compensation circuit including a control clock signal generating circuit, as a further embodiment of an analog signal processor of the present invention.

Fig. 23 is a waveform diagram showing a waveform of a control clock signal generated in the control clock signal generating circuit.

Fig. 24 shows an example of an analog signal processing element circuit.

Fig. 25 shows an example of another analog signal processing element circuit.

Fig. 26 shows an example of a further signal processing element circuit.

Fig. 27 shows an example of yet another signal processing element circuit.

Fig. 28 shows an example of still another signal processing element circuit.

Fig. 29 shows an arrangement of a main part of an offset compensation circuit of a conventional switched capacitor filter.

Fig. 30 shows an arrangement of a main part of an offset compensation circuit of another conventional switched capacitor filter.

DESCRIPTION OF THE EMBODIMENTS

[Embodiment 1]

The following description will discuss an embodiment in accordance with the present invention in reference to figs. 1 to 19. By the way, this embodiment describes a case when the present invention is applied to compensate for an offset of an analog signal processing circuit made up of more than one analog signal processing element circuit.

As shown in fig. 1, an analog signal processing circuit 1 with an offset compensation circuit, which is an analog signal processor in accordance with a present invention, includes:

an analog signal processing circuit 2 in which $N$ ($N>1$) analog signal processing element circuits (at least one of them is a switched capacitor circuit) are cascaded; and

an offset compensation circuit 3 for automatically compensating for an offset voltage produced in an output signal of the analog signal processing circuit 2.

The analog signal processing circuit 2 is made up of $N$ analog signal processing element circuits 2-1 to 2-N:

from a first analog signal processing element circuit 2-1 to which an analog signal to be processed is input; to an N-th analog signal processing element circuit 2-N from which an already processed analog signal is transmitted. Among these analog signal processing element circuits 2-1 to 2-N, one or more than one n-th analog signal processing element circuit 2-n (n is an arbitrary natural number from 1 to *N*) is a switched capacitor circuit.

The type of this switched capacitor circuit is not particularly determined so that it is possible to use conventionally known switched capacitor circuits such as a switched capacitor filter described in Japanese Laid-Open Patent Application No. 61-196612 (Tokukaisho 61-196612; published on August 30, 1986), a conventionally known switched capacitor digital/analog converter, and other analog signal processing element circuits using conventionally known switched capacitor circuits (amplifier, integrator, buffer, digital/analog converter, etc.).

Incidentally, in the offset compensation circuit of the aforementioned Application, the type of the circuit to be an object of the offset compensation is either a switched capacitor bandpass filter or a switched capacitor low-pass filter so that the range of the application is limited. The conventional Application does not describe offset compensation of other circuits, for instance, other switched capacitor circuits such as a switched capacitor digital/analog converter. However, those other switched capacitor circuits such as a switched capacitor digital/analog converter have to be compensated the offset thereof too.

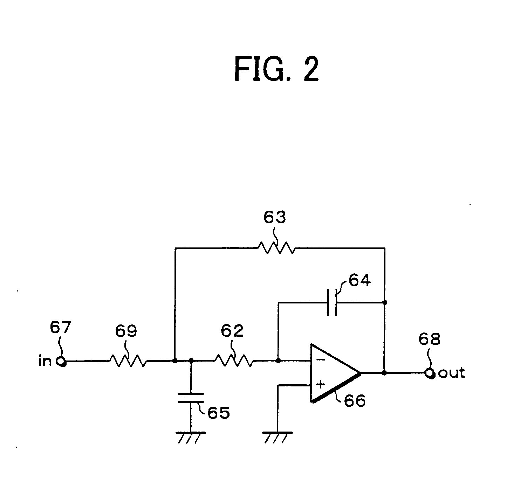

In the meantime, the present invention can be applied for compensating for not only the offset of the switched capacitor filter but also that of other switched capacitor circuits so that it is possible to compensate for the offset of those switched capacitor circuits other than the switched capacitor filter. Moreover, the analog signal processing circuit 2 may include an analog signal processing element circuit other than the switched capacitor circuit, for instance, a continuous-time circuit such as a continuous-time filter shown in fig. 2. In this case it is possible to compensate for an offset of an analog signal processing element circuit other than the switched capacitor circuit.

The continuous-time filter shown in fig. 2 includes:

an operational amplifier 66 whose output terminal is connected to an output end 68 and whose plus input terminal is grounded;
resistances 69 and 62 connected in series and in this order from the input side, and provided between an input end 67 and a minus input terminal of the operational amplifier 66;
a resistance 63 connected to: a junction of the resistances 69 and 62; and the output terminal of the operation amplifier 66;
a capacitor 64 connected to the minus input terminal of the operational amplifier 66 and the output terminal thereof; and
a capacitor 65 connected to the junction of the resistances 69 and 62, and also grounded.

The offset compensation circuit 3 includes:

an offset detecting circuit 4, which is connected to the N-th analog signal processing element circuit 2-N to detect low frequency components of an output signal of the analog signal processing circuit 2, including the offset voltage thereof;
a negative feedback path 6 for feeding an output signal (detected low frequency components) of the offset detecting circuit 4 back to the analog signal processing circuit 2; and
a subtraction circuit 5 (adding-subtracting circuit) for subtracting the output signal of the offset detecting circuit 4, which is fed back via the negative feedback path 6, from an input signal 8 which is an analog signal to be processed.

The subtracting circuit 5 is provided on a wire for inputting the analog signal to be processed to the input end of the analog signal processing circuit 2. In other words, the subtracting circuit 5 is arranged so that an output terminal thereof is connected to the input end of the analog signal processing circuit 2 and the analog signal to be processed is transmitted to a plus input terminal of the subtracting circuit 5. Meanwhile, a minus input terminal of the subtracting circuit 5 is connected to the output end of the offset detecting circuit 4.

The offset detecting circuit 4 is provided for detecting the low frequency components (components below a certain frequency) including the offset voltage in the output signal of the analog signal processing circuit 2, and transmitting the detected low frequency components to the subtracting circuit 5 via the negative feedback path 6. In other words, only low frequency components (components below a certain frequency) including the offset voltage, for instance, frequency components below 10Hz can pass through the offset detecting circuit 4, and at the same time the gain of the circuit 4 with respect to DC (0Hz) is high enough. By the way, the analog signal processed in the analog signal processing circuit 2 in accordance with the present invention includes components having frequencies higher than the passband of the offset detecting circuit 4, and DC of the signal does not include information. An example of this analog signal is a signal having frequencies not less than 1MHz.

Now, in the following equations:

gains of *N* analog signal processing element circuits 2-p (p=1,2, ···, *N*), from the first analog signal processing element circuit 2-1 to the N-th analog signal processing element circuit 2-N, are taken as $G_p$ ($G_1$, $G_2$, ···, $G_N$) ; input-converted offset voltages of *N* analog signal processing element circuits 2-p are taken as $O_p$ ($O_1$, $O_2$, ···, $O_N$) ; a gain of the offset detecting circuit 4 is taken as F (>0) ; a voltage of the input signal 8 is taken as Vin whereas that of the output signal 9 is taken as Vout; and the relationship between the input and output (relationship between Vin and Vout) is represented as a transfer function below.

[Eq. 1]

$$Vout = \frac{G_1 G_2 ... G_N}{1 + G_1 G_2 ... G_N F} Vin + \frac{O_0}{1 + G_1 G_2 ... G_N F} \tag{1}$$

$$O_0 = G_1 G_2 \cdots G_N O_1 + G_2 G_3 \cdots G_N O_2 + \cdots + G_{N-1} G_N O_{N-1} + G_N O_N \tag{2}$$

In the equation above, $O_0$ represents an output offset voltage (output offset voltage of a conventional analog signal processor) of the analog signal processing circuit 2 when the offset compensation circuit 3 is removed from the analog signal processing circuit 1 with the offset compensation circuit.

In the meantime, the voltage Vout' of the output signal 9, when the offset compensation circuit 3 is removed from the analog signal processing circuit 1 with the offset compensation circuit, is represented as an equation below.

$$Vout' = G_1 G_2 \cdots G_N Vin + O_0 \tag{3}$$

Figs. 3(a) to 3(c) show variations (variation of the voltage V over a period of time t) of the voltage Vin of the input signal 8 and the voltages Vout and Vout' of the output signal 9 with respect to time, in the present case.

When the input signal 8 having the voltage Vin shown in fig 3(a) is provided, the voltage Vout' of the output signal 9 of the analog signal processing circuit 2, in the case when the offset compensation circuit 3 shown in eq. (3) is removed, shifts the center thereof for an amount of the output offset $O_0$ with respect to the center (average, 0 in this case) of the voltage level Vin of the input signal 8, as fig. 3(b) shows.

Meanwhile, a gain F with respect to the DC (0Hz) of the offset detecting circuit 4 is high enough so that it can be regarded as the gain F→∞, in the case of the analog signal processing circuit 1 with the offset compensation circuit in accordance with the present invention to which the offset compensation circuit 3 is connected. Thus it can be regarded as $G_1 G_2 \cdots G_N F \to \infty$, so the term (second term) of the offset in eq. (1) is dismissed so that Vout of the output signal 9 is represented as an equation (4) below.

[Eq. 2]

$$Vout = \frac{G_1 G_2 ... G_N}{1 + G_1 G_2 ... G_N F} Vin \tag{4}$$

Thus the output offset of the analog signal processing circuit 2 in the DC (0Hz) is zero. As a result, if the offset voltage is sorely made up of the DC component (0Hz), the offset voltage is completely cancelled. In this case Vout of the DC (0Hz) is zero so that no DC component included in the signal goes through either. However, this does not cause any problem since no information is contained in the DC of the input signal 8.

In the meantime, when:

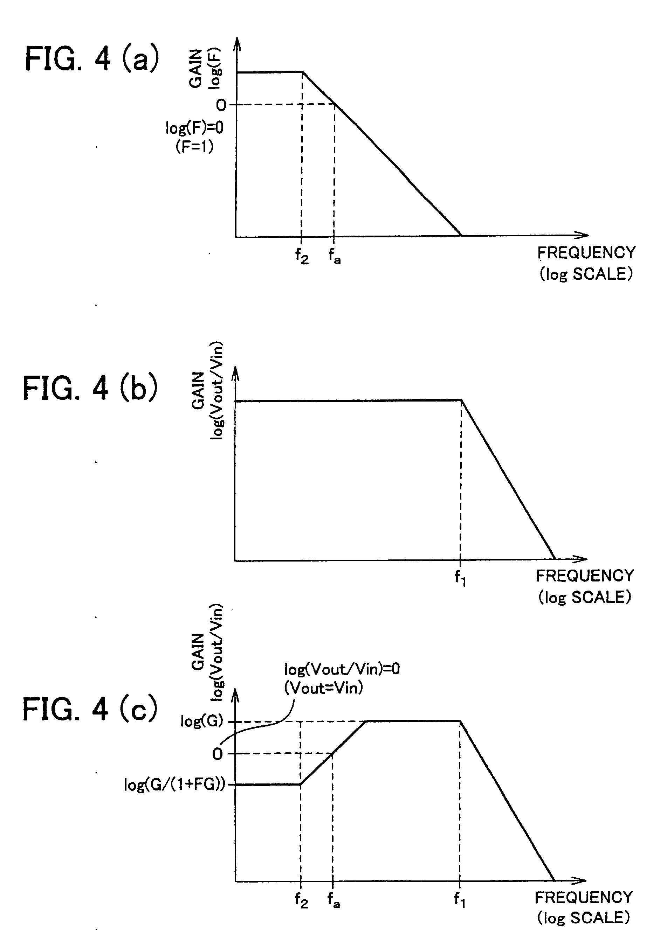

either the input signal 8 or the output signal 9 is taken as a signal having information in a bandwidth up until a certain frequency $f_1$ (>0);
the offset detecting circuit 4 has a frequency response as shown in fig. 4(a) and a passband thereof is not more

than a frequency $f_2$; and
a frequency F=1 is taken as $f_a$,

F equals zero in the case of a signal having a frequency higher than the frequency $f_a$. Eq. (4) holds for $f_1 > f_2$, since the offset in eq. (1) which is a DC component no longer exists. Moreover, since F→0, an equation:

$$Vout=G_1G_2\cdots G_N Vin$$

holds. For instance, as shown in fig. 4(a), if it is taken as:

the offset detecting circuit 4 has a passband up until $f_2$=10Hz;
the gain F in DC is F»G (ideally in DC and F→∞); and
the input signal 8 is a signal having information in a band up until $f_1$=100kHz and does not contain information in the DC thereof,

the relationship between Vout and Vin is as shown in fig. 4(c).

That is to say, the gain F of the offset detecting circuit 4 with respect to DC is huge so that the signal and offset are cancelled in the DC (0Hz). In other words, when the frequency f=0, the offset does not exist since it is DC. Moreover, in a certain frequency $f=F_a$ in which F=1, the output Vout equals to Vin. Furthermore, when $f_2 < f < f_1$, the output Vout is:

$$Vout=G_1G_2\cdots G_N Vin$$

As shown above, in the analog signal processing circuit 1 with the offset compensation circuit shown in fig. 1, it is possible to cancel the offset component using the difference between the frequency of the input signal 8 and that of the offset voltage. The output signal 9 in this case is shown in fig. 3(c).

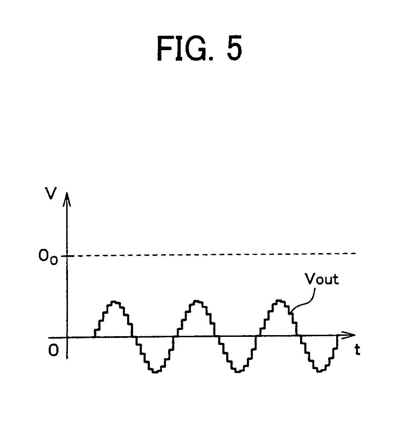

Incidentally, although the input signal 8 and the output signal 9 are both indicated as continuous-time analog signals in figs. 3(a) to 3(c), the input signal 8 and the output signal 9 can be a discrete-time signal, a digital signal, etc. Fig. 5 shows an example of variations of a voltage Vout of a discrete-time output signal 9 with respect to time. Furthermore, in the analog signal processing circuit 2, an analog signal may change the state to be a continuous-time analog signal, discrete-time signal or a digital signal, according to the location.

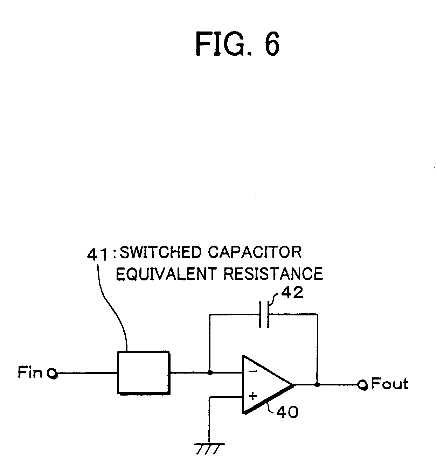

Next, what will be described is an example of the offset detecting circuit 4 that can be used in the present embodiment and other embodiments described later, with reference to fig. 6.

The offset detecting circuit 4 of this example is a switched capacitor offset voltage detecting circuit, as fig. 6 shows, including:

an operational amplifier (first operational amplifier) 40;
a signal input end Fin to which the output signal of the analog signal processing circuit 2 is transmitted;
a switched capacitor equivalent resistance 41 connected to the signal input end Fin and a minus input terminal of the operational amplifier 40; and
a first capacitor (capacitor) 42 connected to the minus input terminal and an output terminal of the operational amplifier 40.

The offset detecting circuit 4 is further arranged so that a plus input terminal of the operational amplifier 40 is grounded and the output terminal of the operational amplifier 40 is connected to an offset compensation signal input end Fout which is one of two input ends of the subtraction circuit 5.

The switched capacitor equivalent resistance 41 can include:

one or more than one capacitor;
one pair or more than one pair of switches on the input side, provided: between a terminal of the capacitor and an input end; and between the terminal and a grounding potential; and
a switched capacitor including one pair or more than one pair of switches on the output side, provided: between the other terminal of the capacitor and an output end; and between the other terminal and a grounding potential.

Two switches constituting each pair of the switches are controlled respectively by a first clock signal and a second control signal that are of opposite polarity, and the switch is continuous (ON) when the clock signal is at a high level (H), while the switch is interrupted (OFF) when the clock signal is at a low level (L). Thus the two switches constituting each pair of the switches alternately turn to be continuous or interrupted, and when one of the switches is continuous, the other is interrupted. Switching between the continuous state and the interrupted state on the input side and the same procedure on the output side are in sync with each other.

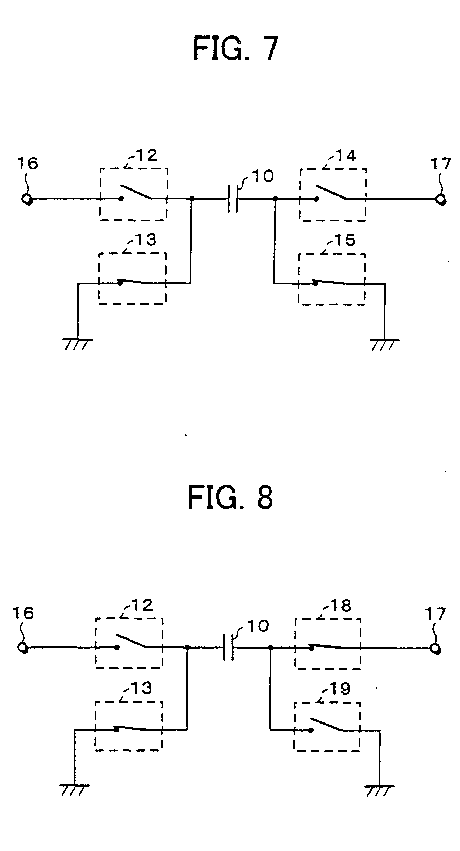

Examples of a switched capacitor that can be used as the switched capacitor equivalent resister 41 are shown in figs. 7 to 10.

A switched capacitor shown in fig. 7 includes:

a second capacitor 10;
a pair of switches 12 and 13 on the input side, provided: between a terminal of the second capacitor 10 and an input end 16; and between the terminal and a grounding potential; and
a pair of switches 14 and 15 on the output side, provided: between the other terminal of the second capacitor 10 and an output end 17; and between the other terminal and a grounding potential.

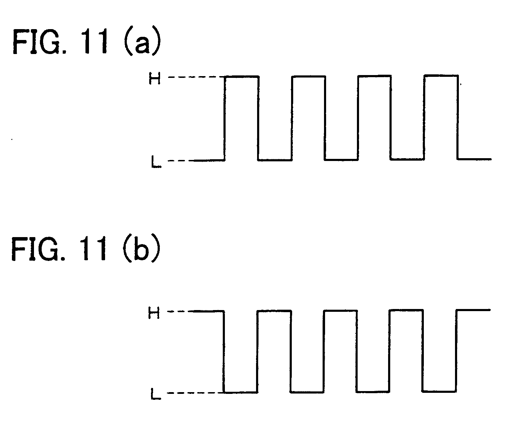

While the switches 12 and 14 are controlled by a first clock signal shown in fig. 11(a), the switches 13 and 15 are controlled by a second clock signal shown in fig. 11(b). Thus the both terminals of the second capacitor 10 are connected to the input end 16 and the output end 17 respectively when the first clock signal is H, whereas the both terminals are grounded as shown in fig. 7 when the first clock signal is L.

A switched capacitor shown in fig. 8 includes switches 18 and 19 on the output side instead of the switches 14 and 15 on the output side that are included in the switched capacitor shown in fig. 7, and while the switch 19 is controlled by the first clock signal shown in fig. 11(a), the switch 18 is controlled by the second clock signal shown in fig. 11(b). Thus the input end 16 is grounded via the second capacitor 10 when the first clock signal is H, whereas as fig. 8 shows, the output end 17 is grounded via the second capacitor 10 when the first clock signal is L.

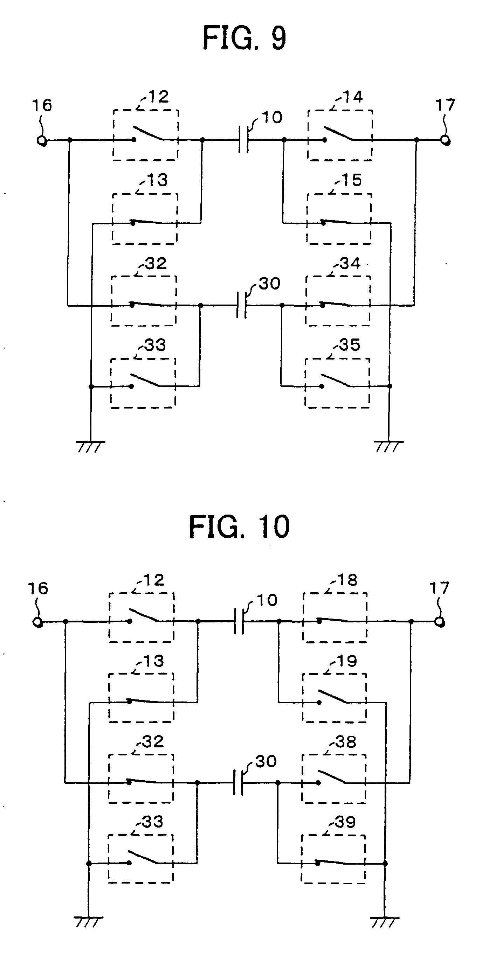

A switched capacitor shown in fig. 9 is equivalent to a side-by-side configuration of the switched capacitor shown in fig. 7 and a switched capacitor identical with the switched capacitor shown in fig. 7 except that the same operates in opposite phase. Thus in addition to the components of the switched capacitor shown in fig. 7, the switched capacitor shown in fig. 9 includes:

a second capacitor 30;
a switch 33 on the input side and a switch 35 on the output side that are controlled by the first clock signal shown in fig. 11(a); and
a switch 32 on the input side and a switch 34 on the output side that are controlled by the second clock signal shown in fig. 11(b).

Both terminals of the second capacitor 30 are grounded when the first clock signal is H, whereas the both terminals are respectively connected to the input end 16 and the output end 17 as shown in fig. 9, when the first clock signal is L.

A switched capacitor shown in fig. 10 is equivalent to a side-by-side configuration of the switched capacitor shown in fig. 8 and a switched capacitor identical with the switched capacitor shown in fig. 8 except that the same operates in opposite phase. Thus in addition to the components of the switched capacitor shown in fig. 8, the switched capacitor shown in fig. 10 includes:

the second capacitor 30;
the switch 33 on the input side and a switch 39 on the output side that are controlled by the first clock signal shown in fig. 11(a); and
the switch 32 on the input side and a switch 38 on the output side that are controlled by the second clock signal shown in fig. 11(b).

When the first clock signal is H, the output end 17 is grounded via the second capacitor 30, whereas the input end 16 is grounded via the second capacitor 30 as shown in fig. 10, when the first clock signal is L.

An offset detecting circuit shown in fig. 6 operates as a single-ended switched capacitor integrator circuit, even if any one of the switched capacitors shown in figs. 7 to 10 is used as the switched capacitor equivalent resistance 41. A transfer function H(z) of the offset detecting circuit 4 is, as an equation below shows, proportional to $C_{13}/C_{12}$ which is a ratio of a capacity $C_{12}$ of the first capacitor 42 to a capacity $C_{13}$ of the second capacitor 10 (and 30).

[Eq. 3]

$$H(z) \propto \frac{C_{13}}{C_{12}} \qquad (5)$$

In an integrator circuit, ideally DC gain H ($z=1$) is infinite. Thus an offset detecting circuit, operating as this type of integrator circuit with respect to an offset voltage that is a DC component, has a huge gain so that a condition to acquire the aforementioned equations (1) to (4) (or a condition to acquire equations (7) and (8) described later), that is, a condition when the gain F of the offset detecting circuit 4 is huge with respect to the offset voltage is:

$$F = |H(z=1)| = \infty \qquad (6)$$

Thus the gain F of the offset detecting circuit 4 which is an integrator circuit is huge with respect to the offset voltage which is a DC component, and hence it is possible to cancel the offset voltage.

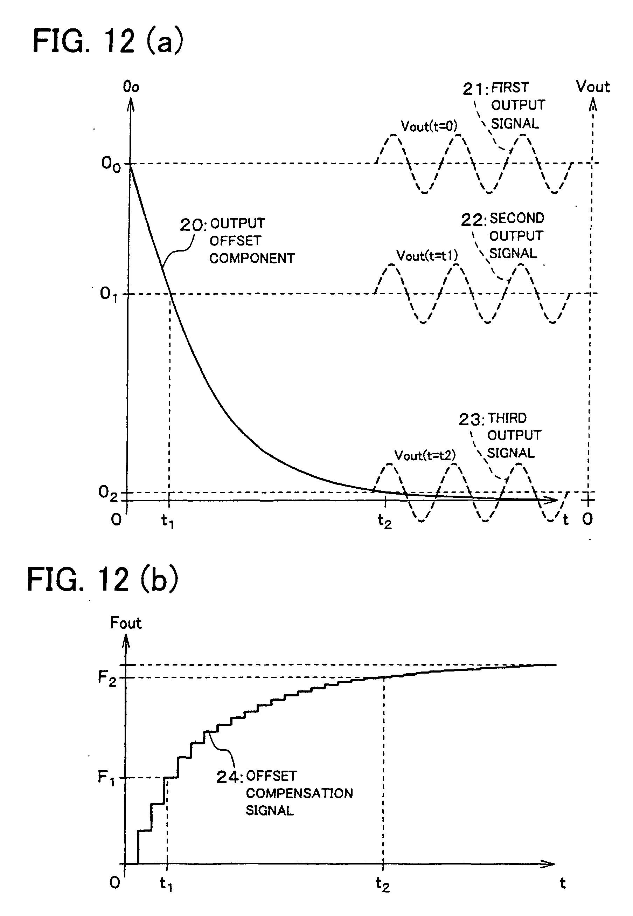

Now, in reference to figs. 12(a) and 12(b), what will be described is a process of offset voltage compensation when the offset detecting circuit 4 shown in fig. 6 is employed in the analog signal processing circuit 1 with the offset compensation circuit as shown in fig. 1.

A first output signal 21, a second output signal 22, and a third output signal 23 indicate the states of the output signal 9 of the analog signal processing circuit 1 with the offset compensation circuit, respectively after periods of time of $t=0$, $t=t_1$, $t=t_2$ ($0<t_1<t_2$) have past from the instant, which is taken as $t=0$, when the circuit starts to operate (instant when the analog signal processing circuit 1 with the offset compensation circuit starts to operate). An offset component 20 only describes how an offset voltage component included in the output signal 9 of the analog signal processing circuit 1 with the offset compensation circuit varies with respect to the time elapsed from the start of the circuit. Meanwhile an offset compensation signal 24 describes how the output signal of the offset detecting circuit 4 varies with respect to the time elapsed from the start of the circuit.

When the analog signal processing circuit 1 with the offset compensation circuit starts to operate at $t=0$, the output signal 9 of the analog signal processing circuit 1 with the offset compensation circuit is transmitted while being shifted as much as an amount of the output offset voltage $O_0$ as the first output signal 21 shown in fig. 12(a) indicates. The output signal of the offset detecting circuit 4 is zero as an offset compensation signal 24 shown in fig. 12(b) indicates, since the offset detecting circuit 4 cannot yet detect the output offset voltage $O_0$ of the analog signal processing circuit 2 at this moment.

Then a case when $t=t_1$ is considered. When the offset detecting circuit 4 detects the output offset voltage $O_1$ of the analog signal processing circuit 2, a voltage of the output signal of the offset detecting circuit 4 is $F_1$, as the offset compensation signal 24 indicates. The output signal of the offset detecting circuit 4 is added or subtracted to be negative feedback to the analog signal processing circuit 2 so that the offset voltage of the analog signal processing circuit 2 is reduced as much as an amount of the offset compensation signal 24, i.e. an amount of $F_1$. On this account, the output offset component 20 is reduced to $O_2$. Thus when $t=t_1$, a voltage Vout ($t=t_1$) of the output signal 9 of the analog signal processing circuit 1 with the offset compensation circuit approaches to zero as much as an amount of the offset voltage $O_2$, as the second output signal 22 shown in fig. 12(a) indicates.

Then a case when $t=t_2$ is considered. Since the offset detecting circuit 4 already detects $O_2$ of the output offset component 20 of the analog signal processing circuit 2 whose offset voltage is partly cancelled, the offset compensation signal 24, having a voltage $F_2$ greater than the voltage $F_1$ in the case of $t=t_1$, is transmitted. On this account, the output offset component 20 of the analog signal processing circuit 2 is further reduced, and hence when $t=t_2$, a voltage Vout ($t=t_2$) of the output signal 9 of the analog signal processing circuit 1 with the offset compensation circuit further approaches zero, as the third output signal 23 shown in fig. 12(a) indicates. In this manner, the output offset voltage of the analog signal processing circuit 1 with the offset compensation circuit is cancelled after a sufficiently long time has past.

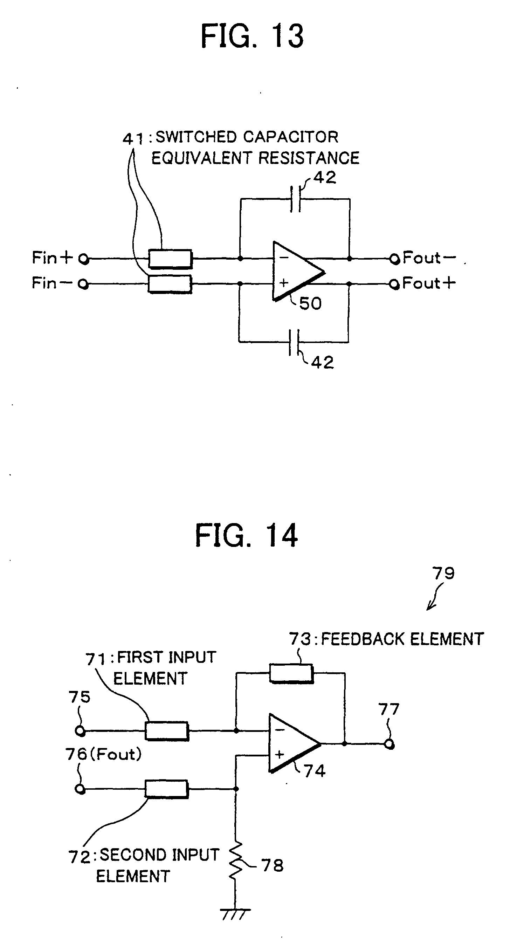

Incidentally, a full-differential switched capacitor integrator circuit shown in fig. 13 can be effectively used as the offset detecting circuit 4. Fig. 13 shows an example of an offset detecting circuit of full-differential type, which has often been used for an analog signal processing circuit which is a differentiator.

The full-differential switched capacitor integrator circuit shown in fig. 13 includes:

an operational amplifier 50 (first operational amplifier) including a minus input terminal, a plus input terminal, a minus output terminal, and a plus output terminal;

signal input ends Fin+ and Fin- to which the output signal of the analog signal processing circuit 2 is transmitted; the switched capacitor equivalent resistance 41 connected to the signal input end Fin+ of the operational amplifier 50 and the minus input terminal thereof;

the switched capacitor equivalent resistance 41 connected to the signal input end Fin- and the plus input terminal of the operational amplifier 50;

the first capacitor (capacitor) 42 connected to the minus input terminal of the operational amplifier 50 and the minus output terminal thereof; and

the first capacitor (capacitor) 42 connected to the plus input terminal and the plus output terminal of the operational amplifier 50,

in which the minus output terminal of the operational amplifier 50 is connected to an offset compensation signal input end Fout- which is an input end of the subtraction circuit 5, whereas the plus input terminal of the operational amplifier 50 is connected to an offset compensation signal input end Fout+ which is also an input end of the subtraction circuit 5.

This offset detecting circuit is of a differential type so that addition and subtraction can be done simply by changing a connection of the signal terminal. Thus this contributes to simplify an arrangement of the circuit, compared to an arrangement of the circuit (non-differential circuit) in which an inverting circuit must be used.

By the way, other offset detecting circuits such as an offset detecting circuit described in Japanese Laid-Open Patent Application No. 61-196612 (Tokukaisho 61-196612; published on August 30, 1986) may be used as the offset detecting circuit 4.

Next, a differential input type subtraction circuit will be described as an example of a subtraction circuit which can be used as the subtraction circuit 5 of the present embodiment and other embodiments described later, with reference to fig. 14.

As shown in fig. 14, a differential input type subtraction circuit 79 of the present example includes:

an operational amplifier 74 whose plus input terminal is grounded via a resistance 78;

a signal input end 75 to which the analog signal 8 (voltage Vin) to be processed is transmitted;

a first input element 71 connected to the signal input end 75 and a minus input end of the operational amplifier 74;

an offset compensation signal input end 76 (Fout) connected to the output end of the offset detecting circuit 4;

a second input element 72 connected to the offset compensation signal input end 76 and a plus input terminal of the operational amplifier 74;

a feedback element 73 connected to the minus input terminal of the operational amplifier 74 and the output terminal thereof; and

a signal output end 77 connected to the output terminal of the operational amplifier 74, for transmitting an output signal of the operational amplifier 74 to the analog signal processing circuit 2.

It is possible to use a resistance or a switched capacitor equivalent resistance for the first input element 71 and the second input element 72. As for the feedback element 73, it is possible to use a resistance, a switched capacitor equivalent resistance, or a capacitor.

It is obvious that other conventionally known analog subtraction circuits can be used as the subtraction circuit 5 of the present embodiment and other embodiments described later. Also, what is required for an adding-subtracting circuit of the present invention is simply adding or subtracting the output of the offset detecting circuit 4 to/from the input signal 8, to cancel the offset voltage. Thus an adder circuit can be used instead of the subtraction circuit 5, if the polarity of the output signal of the offset detecting circuit 4 is inverted.

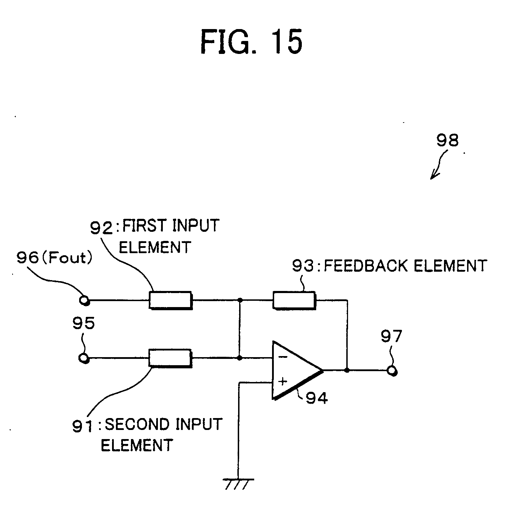

An adder circuit which can be used instead of the subtracting circuit 5 is, for instance, an inversion adder circuit 98 shown in fig. 15. As fig. 15 shows, the inversion adder circuit 98 includes:

an operational amplifier 94 (second operational amplifier) whose plus input terminal is grounded;

a signal input end 95 to which the analog signal 8 (voltage Vin) to be processed is transmitted;

a first input element 91 connected to the signal input end 95 and a minus input terminal of the operational amplifier 94;

an offset compensation signal input end 96 (Fout) connected to the output end of the offset detecting circuit 4;

a second input element 92 (input element) connected to the offset compensation signal input end 96 and the minus input terminal of the operational amplifier 94;

a feedback element 93 connected to the minus input terminal of the operational amplifier 94 and the output terminal thereof; and

a signal output end 97 connected to the output terminal of the operational amplifier 94, for transmitting the output signal of the operational amplifier 94 to the analog signal processing circuit 2.

It is possible to use a resistance or a switched capacitor equivalent resistance for the first input element 91 and the second input element 92. As for the feedback element 93, it is possible to use a resistance, a switched capacitor equivalent resistance, or a capacitor.

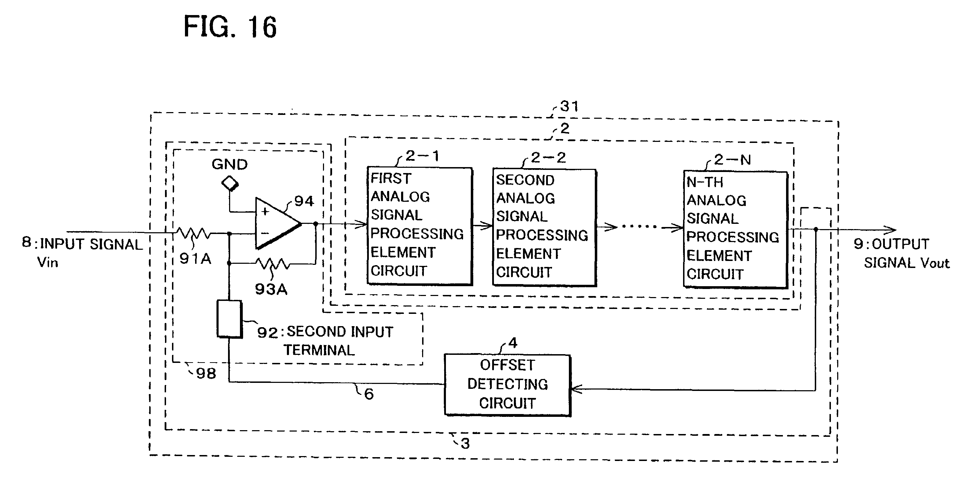

Next, fig. 16 shows an example of an arrangement of an analog signal processing circuit with an offset compensation circuit, which uses the inversion adder circuit 98 instead of the subtraction circuit 5 used in the analog signal processing circuit 1 with the offset compensation circuit shown in fig. 1.

As shown in fig. 16, an analog signal processing circuit 31 (analog signal processor) with the offset compensation circuit, which is of the example above, is arranged so that:

the inversion adder circuit 98 is used instead of the subtraction circuit 5 in the analog signal processing circuit 1 with the offset compensation circuit; and
a resistance 93A is used as the feedback element 93 whereas a resistance 91A is used as the first input element 91.

Sections of the inversion adder circuit 98 except the second input element 92 perform as an amplifier implemented by a continuous-time analog circuit. In this arrangement, the output signal of the offset detecting circuit 4 is transmitted to the minus input terminal of the operational amplifier 94 via the second input element 92 made up of a simple resistance or a switched capacitor equivalent resistance. In this manner, it is possible to add/subtract the output signal of the offset detecting circuit 4 and transmit the same.

The sections of the inversion adder circuit 98 except the second input element 92 can be regarded as an analog signal processing element circuit (hereinafter, these sections are termed an analog signal processing element circuit section). Although in fig. 16 an adding-subtracting circuit is seen to be made up of the analog signal processing element circuit section and the second input element 92, the analog signal processing element circuit section is originally a part of the analog signal processing circuit so that the section does not inherently have a function to add an offset voltage. As an example, fig. 16 illustrates the analog signal processing element circuit section as an amplifier. Without connecting the second input element 92, which inputs the output of the offset detecting circuit 4, to the section above, the same cannot operate as an adding-subtracting circuit that adds/subtracts the offset voltage. The arrangement shown in fig. 16 is characterized in that an operational amplifier is not additionally provided as the adding-subtracting circuit, and hence it is possible to reduce the occupied area and power consumption. Thus the arrangements in fig. 1 and fig. 16 are different when the analog signal processing element circuit section is regarded as a part of the analog signal processing circuit.

Incidentally, the offset compensation circuit in accordance with the present invention is not an almighty circuit that can compensate for an offset of any kind of analog signal processor, i.e. the circuit cannot compensate for some kinds of offsets. The offset compensation is not possible, for instance, when offsets of all stages of the analog signal processing circuit 2 (analog signal processing element circuits 2-1 to 2-N) are huge, and when gains of all stages (analog signal processing element circuits 2-1 to 2-N) are huge.

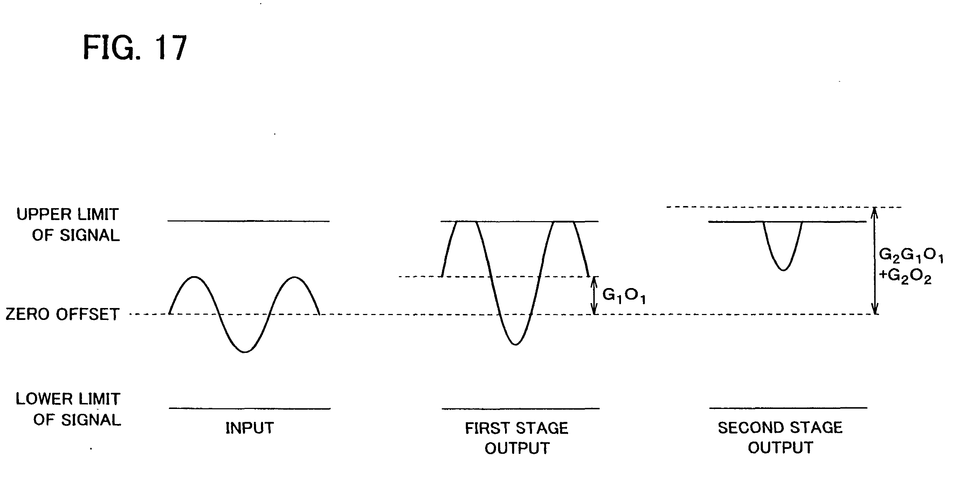

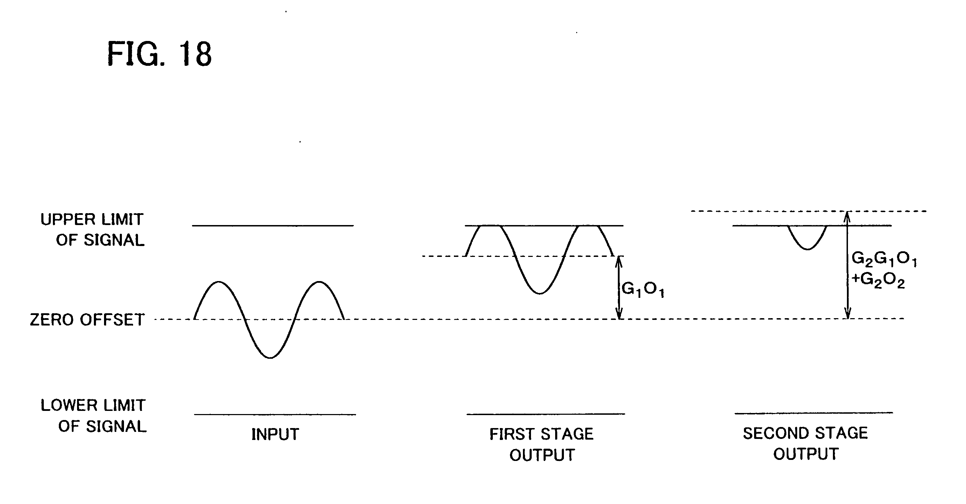

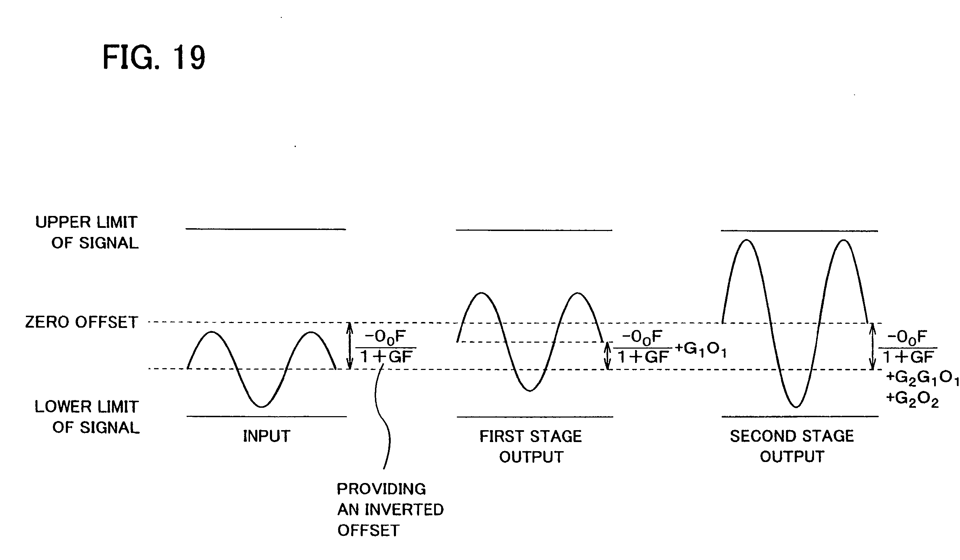

When limits within which the signal of each of the stages is not saturated are clearly described as in figs. 17 to 19, the offset compensation may be impossible when a gain shown in fig. 17 is huge or when an offset shown in fig. 18 is huge. However, in reality the circuit is designed on the basis of a sufficient estimation of these limits, and it is also possible to choose a differently arranged circuit. Moreover, as fig. 19 shows, it is possible to prevent saturation in the middle stage of the analog signal processing circuit 2 and compensate for the offset in the output of the analog signal processing circuit 2, by providing a virtually inverted offset in the offset detecting circuit 4. So it is possible to determine not only an amount of the voltage to be simply subtracted but also an amount of the voltage to be added as the inverted offset voltage, because feedback is applied to all of the circuit owing to the feedback path.

[Embodiment 2]

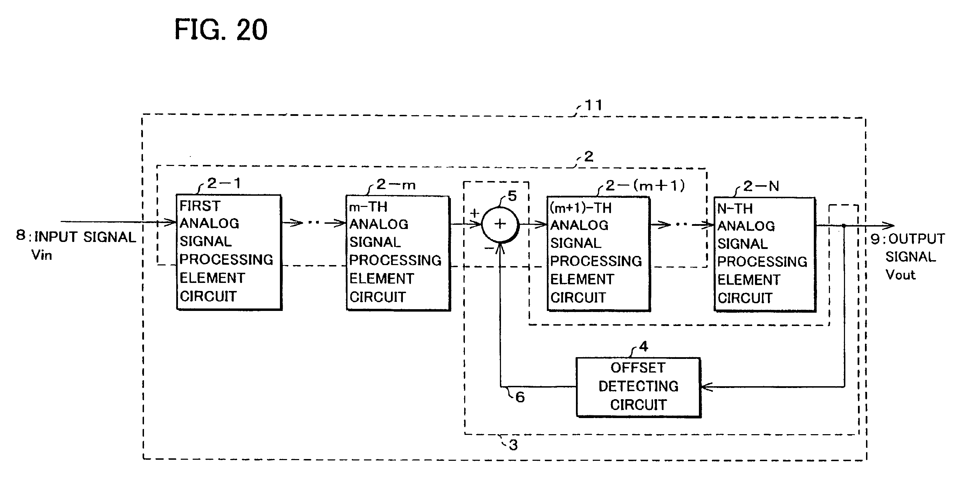

The following description will discuss another embodiment in accordance with the present invention in reference to fig. 20. By the way, members having the same functions as those described in Embodiment 1 are given the same numbers, so that the descriptions are omitted for the sake of convenience.

An analog signal processing circuit 11 with an offset compensation circuit as an analog signal processor in accordance with the present invention is arranged identically with the analog signal processing circuit 1 with the offset compensation circuit described in Embodiment 1, except that the subtraction circuit 5 is provided on a wire (wire inside the analog signal processing circuit) between a m-th analog signal processing element circuit 2-m and a (m+1)-th analog signal processing element circuit 2-(m+1) among $N$ ($N{\geq}2$) analog signal processing element circuits including at least one switched capacitor circuit, providing that $1{\leq}m{<}N$.

In this case the subtraction circuit 5 subtracts the output signal (low frequency elements) of the offset detecting circuit 4, that is fed back via the feedback path 6, from an output signal of the m-th analog signal processing element circuit 2-m connected just before the circuit 5.

An output of the analog signal processing circuit 11 with the offset compensation circuit is described as an equation below.

[Eq. 4]

$$Vout = \frac{G_1 G_2 ... G_N}{1 + G_{m-1} G_{m-2} ... G_N F} Vin + \frac{O_0}{1 + G_{m-1} G_{m-2} ... G_N F} \qquad (7)$$

In the analog signal processing circuit 11 with the offset compensation circuit in accordance with the present embodiment, the gain F of the offset detecting circuit 4 is also high enough in DC as in Embodiment 1, so that it is possible to regard as $G_{m+1} G_{m+2} \cdots G_N F$ is high enough. Thus the second term of eq. (7) is cancelled in the case of DC, so the term including the offset is erased from the output of the analog signal processing circuit 2 and hence described as an equation below.

[Eq. 5]

$$Vout = \frac{G_1 G_2 ... G_N}{1 + G_{m-1} G_{m-2} ... G_N F} Vin \qquad (8)$$

In this manner, it is possible to cancel the DC offset in the analog signal processing circuit 11 with the offset compensation circuit in accordance with the present embodiment, as in Embodiment 1.

[Embodiment 3]

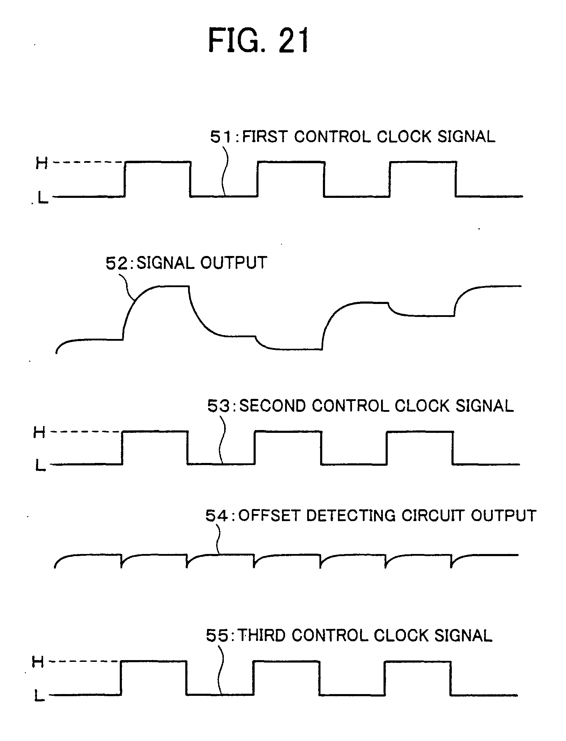

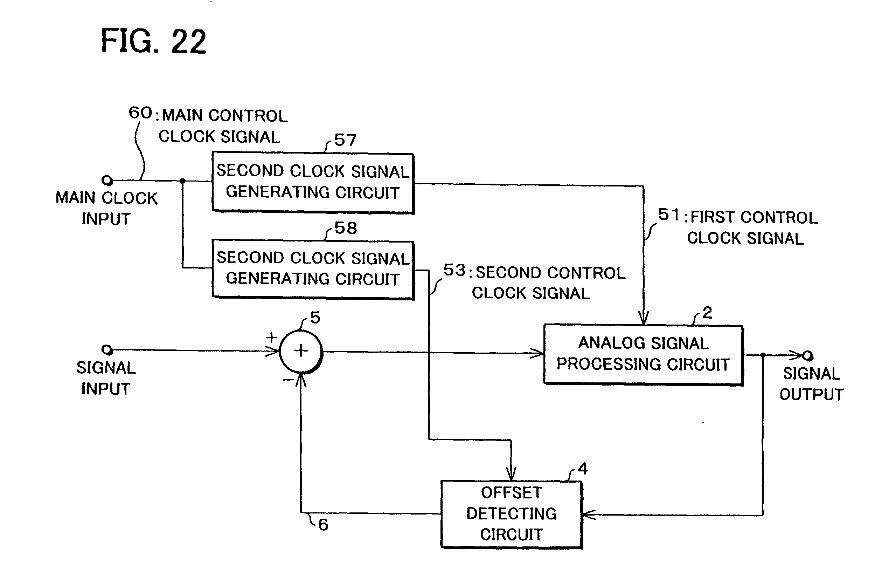

The following description will discuss another embodiment in accordance with the present invention in reference to figs. 21 to 23. By the way, members having the same functions as those described in Embodiments 1 and 2 are given the same numbers, so that the descriptions are omitted for the sake of convenience.
As an analog signal processor in accordance with the present embodiment, an analog signal processing circuit 61 with an offset compensation circuit is, as fig. 22 shows, arranged identically with the analog signal processing circuit 1 with the offset compensation circuit or the analog signal processing circuit 11 with the offset compensation circuit, except that a first clock signal generating circuit 57 (first clock signal providing means) and a second clock signal generating circuit 58 (second clock signal providing means) are added. Moreover, although unillustrated, the offset detecting circuit 4 is the aforementioned switched capacitor integrator circuit shown in fig. 6.
The first clock signal generating circuit 57 generates a first control clock signal 51, which is for controlling a switched capacitor circuit 2-n included in an analog signal processing circuit 2, from a main control clock signal 60, and provides the generated signal to the switched capacitor circuit 2-n. Meanwhile, the second clock signal generating circuit 58 generates a second control clock signal 53, which is for controlling an offset detecting circuit 4 that is a switched capacitor integrator circuit, from the main control clock signal 60, and provides the generated signal to the offset detecting circuit 4.
Fig. 21 shows a relationship between a control clock signal for controlling the switched capacitor circuit included in the analog signal processing circuit 2 and the operation of an output.
The first control clock signal 51 is a control clock signal of the switched capacitor circuit 2-n included in the analog signal processing circuit 2, and a signal output 52 indicates an output signal of the switched capacitor circuit 2-n. Meanwhile, the second control clock signal 53 is a control clock signal for controlling the offset detecting circuit 4, and an offset detecting circuit output 54 indicates an output signal of the offset detecting circuit 4. Moreover, a third control clock signal 55 indicates a control clock signal for controlling a subtraction circuit 5, used when a switched capacitor equivalent resistance is used as the subtraction circuit 5.
The switched capacitor circuit transmits a signal in a time-discrete manner. Thus if an output of a stage of the switched capacitor circuit is not yet settled, an error is caused in the following stage of the switched capacitor circuit in which the output signal above is sampled.
To prevent the occurrence of the error, in the present embodiment:

the first control clock signal 51 for controlling the switched capacitor circuit 2-n included in the analog signal processing circuit 2;

the second control clock signal 53 for controlling the offset detecting circuit 4; and

the third control clock signal 55 for controlling the subtraction circuit 5 are all in sync with each other, as fig. 21 shows. In other words, edges of the control clock signals 51, 53, and 55 are aligned with each other. On this account, signals are transmitted in the state that all outputs of circuits with a switching operation are settled so that it is possible to avoid the problem of the sampling error.

Incidentally, although:

the first clock signal generating circuit 57 providing the first control clock signal 51 to the analog signal processing circuit 2; and

the second clock signal generating circuit 58 providing the second control clock signal 53 to the offset detecting circuit 4

are separately provided in the arrangement shown in fig. 22, it is possible to use a clock signal generating circuit providing a common clock signal to both the analog signal processing circuit 2 and the offset detecting circuit 4, instead of those circuits above.

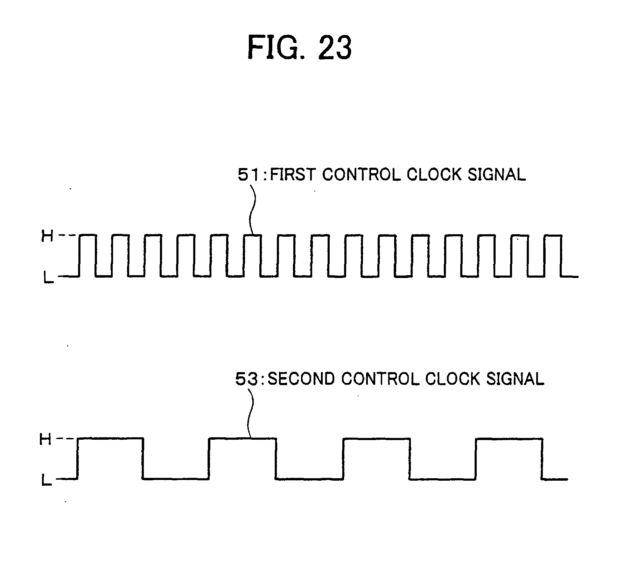

The first clock signal generating circuit 57 and the second clock signal generating circuit 58 of the present embodiment generate the clock signals (the first control clock signal 51 and the second control clock signal 53) that are in sync with each other. However, as fig. 23 shows, the second clock signal generating circuit 58 may generate a clock signal, which is 1/k (k is a natural number more than one) of the first control clock signal 51, as the second control clock signal 53, and provide the same to the offset detecting circuit 4 which is a switched capacitor integrator circuit.

In this case, it is preferable that timing (edge) to change the level of the second control clock signal 53 is completely in sync with that of the first control clock signal 51. That is to say, it is preferable that the second clock signal generating circuit 58 provides a clock signal, which is a divided first control clock signal 51 and in sync with the signal 51, to the offset detecting circuit 4, as the second control clock signal 53.

When a switched capacitor equivalent resistance shown in fig. 7 is used in the offset detecting circuit 4 shown in fig. 6, a transfer function H(z) of the offset detecting circuit 4 is described as eq. (9) below. Moreover, when a frequency, in which an absolute value H(z) of the gain is one, is provided as $f_u$, the capacity ratio given by eq. (5) can be determined by eq. (10).

[Eq. 6]

$$H(z)=-\frac{C_{13}}{C_{12}}\frac{1}{1-z^{-1}} \tag{9}$$

$$\frac{C_{13}}{C_{12}} = \sqrt{2(1-\cos(\frac{2\pi f_u}{f_{s2}}))} \tag{10}$$

It should be noted that $f_{s2}$ is a frequency of the second control clock signal 53 of the offset detecting circuit 4, and $C_{12}$ and $C_{13}$ are a capacity of the first capacitor 42 shown in fig. 6 and a capacity of the second capacitor 10 shown in fig. 7 respectively.

As eq. (10) indicates, it is possible to determine a gain and a band by lowering a sampling velocity $f_{s2}$. For instance, when the frequency $f_s$ of the first control clock signal 51 is 1MHz, a ratio of $C_{13}/C_{12}$, required to cancel an offset up to 1KHz using the second control clock signal 53 having the same frequency, is determined as 0.0063 by eq. (10). It is not possible to produce a fine capacitor smaller than a certain size due to technical limitations, and hence it is not possible to reduce the capacity $C_{13}$ of the second capacitor 10 below a certain capacity. For instance, even if the capacity $C_{13}$ of the second capacitor 10 is reduced to 0.2pF, the capacity $C_{12}$ of the first capacitor 42 is 31.8pF so that a large-sized first capacitor 42 is required, and consequently a considerably large area is required to provide the capacitor 42.

However, if a frequency of the second control clock signal 53 of the offset detecting circuit 4 is divided into 1/10 so as to be 100kHz, the aforementioned ratio of $C_{13}/C_{12}$ required to cancel an offset up to 1kHz is determined as 0.063 by eq. (10). Thus when the capacity $C_{13}$ of the second capacitor 10 is determined as 0.2pF again, the capacity

$C_{12}$ can be fulfilled in the first capacitor 42 having a capacity of 3.18pF, and it is possible to reduce the area necessary to provide the first capacitor 42 to 1/10 of the arrangement above. Moreover, it is possible to manufacture the offset detecting circuit 4 easily, since the area on which the first capacitor 42 is provided is reduced.

Also, when the divided clock signal is used and the signal exists in a lower section of a signal band dealt by the analog signal processing circuit 2, it is possible to broaden the lower section of the band in proportion to the ratio of the division, compared to the offset detecting circuit 4 using the same-sized first capacitor 42 and second capacitor 10 (and second capacitor 30).

Incidentally, instead of a frequency dividing circuit, it is possible to use a frequency multiplier in the first clock signal generating circuit 57 and the second clock signal generating circuit 58 shown in fig. 22, when a higher gain has to be provided for the offset compensation circuit 3 or the time required for the offset compensation is necessary to be reduced. That is to say, it is preferable that the second clock signal generating circuit 58 provides a clock signal, produced by multiplying the first control clock signal 51 and in sync with the signal 51, to the offset detecting circuit 4, as the second control clock signal 53.

Also in this case, it is preferable that the timing (edge) to change the level of the second control clock signal 53 is completely in sync with that of the first control clock signal 51. That is to say, it is preferable that the second clock signal generating circuit 58 provides a clock signal, produced by multiplying the first control clock signal 51 and in sync with the signal 51, to the offset detecting circuit 4, as the second control clock signal 53.

Although the embodiments above describe the arrangements in which the analog signal processing circuit 2 is made up of the more than one analog signal processing element circuit including the switched capacitor circuit, the present invention is also applicable to offset compensation of an analog signal processing circuit made up of a single switched capacitor circuit.

**Claims**

1.  An analog signal processor including:

    an analog signal processing circuit (2) including a switched capacitor circuit (2-n) for processing an analog signal (8); and
    an offset compensation circuit (3) for automatically compensating for an offset voltage produced in an output signal of the analog signal processing circuit (2), the offset compensation circuit (3) including: an offset detecting circuit (4) connected to an output end of the analog signal processing circuit (2) to detect the offset voltage in the output signal of the analog signal processing circuit (2); and a negative feedback path (6) for feeding the offset voltage back to the analog signal processing circuit (2),

    said analog signal processor being **characterized in that** the processor comprises:

    an adding-subtracting circuit (5, 79) for adding or subtracting the offset voltage fed back via the negative feedback path (6) to or from the analog signal (8) processed in the analog signal processing circuit (2),

    wherein the adding-subtracting circuit (5, 79) is connected to an input end of the analog signal processing circuit (2).

2.  An analog signal processor including:

    an analog signal processing circuit (2) including a switched capacitor circuit (2-n) for processing an analog signal (8); and
    an offset compensation circuit (3) for automatically compensating an offset voltage produced in an output signal of the analog signal processing circuit (2), including: an offset detecting circuit (4) connected to an output end of the analog signal processing circuit (2) to detect the offset voltage in the output signal of the analog signal processing circuit (2); and a negative feedback path (6) for feeding the offset voltage back to the analog signal processing circuit (2),

    said analog signal processor being **characterized in that** the processor comprises:

    an adding-subtracting circuit (98) for adding or subtracting the offset voltage fed back via the negative feedback path (6) to or from the analog signal (8) processed in the analog signal processing circuit (2),

    wherein the adding-subtracting circuit (98) is provided on a wire inside the analog signal processing circuit (2).

3. The analog signal processor as set forth in either one of claims 1 and 2, wherein the analog signal processing circuit (2) is made up of more than one analog signal processing element circuit (2-1 to 2-N).

4. The analog signal processor as set forth in claim 2, wherein the analog signal processing circuit (2) is made up of more than one analog signal processing element circuit (2-1 to 2-N), and the adding-subtracting circuit (98) is provided on the wire connecting the more than one analog signal processing circuit (2-1 to 2-N).

5. The analog signal processor as set forth in any one of claims 1 to 4, wherein the adding-subtracting circuit (5, 79, 98) has an amplification factor which is more than one with respect to the offset voltage.

6. The analog signal processor as set forth in any one of claims 1 to 4, wherein the offset detecting circuit (4) is a switched capacitor integrator circuit (4) including:

   a switched capacitor equivalent resistance (41) to which the output signal of the analog signal processing circuit (2) is supplied;
   a first operational amplifier (40, 50) connected to an output end of the switched capacitor equivalent resistance (41); and
   a capacitor (42) connected to an input end of the first operational amplifier (40, 50) and an output end thereof.

7. The analog signal processor as set forth in claim 6, further comprising:

   first clock signal providing means (57) for providing a first control clock signal (51) for controlling the switched capacitor circuit (2-n) to the switched capacitor circuit (2-n); and
   second clock signal providing means (58) for providing a second control clock signal (53) for controlling the switched capacitor integrator circuit (4) to the switched capacitor integrator circuit (4),

   wherein the second control clock signal (53) is in synchronization with the first control clock signal (51).

8. The analog signal processor as set forth in claim 6, further comprising:

   first clock signal providing means (57) for providing a first control clock signal (51) for controlling the switched capacitor circuit (2-n) to the switched capacitor circuit (2-n); and
   second clock signal providing means (58) for providing a second control clock signal (53) for controlling the switched capacitor integrator circuit (4) to the switched capacitor integrator circuit (4),

   wherein the second clock signal providing means (58) provides a clock signal (51) produced by dividing the first control clock signal (51) to the switched capacitor integrator circuit (4), as the second control clock signal (53).

9. the analog signal processor as set forth in claim 6, further comprising:

   first clock signal providing means (57) for providing a first control clock signal (51) for controlling the switched capacitor circuit (2-n) to the switched capacitor circuit (2-n); and
   second clock signal providing means (58) for providing a second control clock signal (53) for controlling the switched capacitor integrator circuit (4) to the switched capacitor integrator circuit (4),

   wherein the second clock signal providing means (58) provides a clock signal (51) produced by multiplying the first clock signal (51) to the switched capacitor integrator circuit (4), as the second control clock signal (53).

10. The analog signal processor as set forth in any one of claims 1 to 9, wherein the adding-subtracting circuit (5, 79, 98) includes:

    a second operational multiplier (74, 94) including a plus input terminal and a minus input terminal; and
    an input element (72, 92) made up of a resistance element or a switched capacitor equivalent resistance,

    and at least one of the plus and minus input terminals of the second operational amplifier (74, 94) is connected to an output end of the offset detecting circuit (4) via the input element (72, 92).

11. The analog signal processor as set forth in claim 10, wherein the input element (72, 92) is a switched capacitor equivalent resistance.

12. The analog signal processor as set forth in any one of claims 1 to 9, wherein the adding-subtracting circuit (5, 79, 98) includes:

the second operational amplifier (74, 94) having the input and output terminals;
a first input element (71, 91, 91A): connected to an input terminal of the second operational amplifier (74, 94); and to which an analog signal to be processed is transmitted;
a second input element (72, 92) connected to the output end of the offset detecting circuit (4) and the input terminal of the second operational amplifier (74, 94); and
a feedback element (73, 93) connected to the input terminal of the second operational amplifier (74, 94) and the output terminal thereof,

and the first input element (71, 91, 91A), the second input element (72, 92), and the feedback element (73, 93) are at least one element selected from the group consisting of a resistance, a switched capacitor equivalent resistance, and a capacitor.

# FIG. 1

EP 1 225 696 A2

8:INPUT SIGNAL Vin

5

+ +

−

2

2−1 FIRST ANALOG SIGNAL PROCESSING ELEMENT CIRCUIT

2−n n-TH ANALOG SIGNAL PROCESSING ELEMENT CIRCUIT

2−N N-TH ANALOG SIGNAL PROCESSING ELEMENT CIRCUIT

9:OUTPUT SIGNAL Vout

4 OFFSET DETECTING CIRCUIT

6

3

1

# FIG. 2

FIG. 3 (a)

FIG. 3 (b)

FIG. 3 (c)

FIG. 4 (a)

GAIN
log(F)

0

log(F)=0
(F=1)

$f_2$  $f_a$

FREQUENCY
(log SCALE)

FIG. 4 (b)

GAIN
log(Vout/Vin)

$f_1$

FREQUENCY
(log SCALE)

FIG. 4 (c)

GAIN
log(Vout/Vin)

log(Vout/Vin)=0
(Vout=Vin)

log(G)

0

log(G/(1+FG))

$f_2$  $f_a$          $f_1$

FREQUENCY
(log SCALE)

## FIG. 5

# FIG. 6

41 : SWITCHED CAPACITOR
EQUIVALENT RESISTANCE

Fin o ——[ ]—— [>40 —o Fout

42

# FIG. 7

# FIG. 8

# FIG. 9

# FIG. 10

FIG. 11 (a)

FIG. 11 (b)

# FIG. 12 (a)

# FIG. 12 (b)

## FIG. 13

41 : SWITCHED CAPACITOR EQUIVALENT RESISTANCE

42

Fin+ o

Fin− o

Fout−

Fout+

50

42

## FIG. 14

79

73 : FEEDBACK ELEMENT

71 : FIRST INPUT ELEMENT

75

77

76 (Fout)

74

72 : SECOND INPUT ELEMENT

78

# FIG. 15

98

96(Fout)

92:FIRST INPUT
ELEMENT

93:FEEDBACK ELEMENT

95

97

91:SECOND INPUT
ELEMENT

94

EP 1 225 696 A2

## FIG. 16

8 : INPUT SIGNAL
Vin

GND

+ 94
−

91A

93A

92 : SECOND INPUT
TERMINAL

98

6

OFFSET
DETECTING
CIRCUIT

4

31

2

2−1
FIRST
ANALOG
SIGNAL
PROCESSING
ELEMENT
CIRCUIT

2−2
SECOND
ANALOG
SIGNAL
PROCESSING
ELEMENT
CIRCUIT

· · · · ·

2−N
N−TH
ANALOG
SIGNAL
PROCESSING
ELEMENT
CIRCUIT

9 : OUTPUT
SIGNAL Vout

3

# FIG. 17

UPPER LIMIT
OF SIGNAL

ZERO OFFSET

LOWER LIMIT
OF SIGNAL

INPUT

FIRST STAGE
OUTPUT

SECOND STAGE
OUTPUT

$G_1 O_1$

$G_2 G_1 O_1$
$+ G_2 O_2$

EP 1 225 696 A2

# FIG. 18

UPPER LIMIT
OF SIGNAL

ZERO OFFSET

LOWER LIMIT
OF SIGNAL

INPUT

FIRST STAGE
OUTPUT

SECOND STAGE
OUTPUT

$G_1O_1$

$G_2G_1O_1$
$+G_2O_2$

# FIG. 19

UPPER LIMIT OF SIGNAL

ZERO OFFSET

LOWER LIMIT OF SIGNAL

INPUT

$$\frac{-O_0F}{1+GF}$$

PROVIDING AN INVERTED OFFSET

FIRST STAGE OUTPUT

$$\frac{-O_0F}{1+GF} + G_1O_1$$

SECOND STAGE OUTPUT

$$\frac{-O_0F}{1+GF} + G_2G_1O_1 + G_2O_2$$

## FIG. 20

8 : INPUT SIGNAL
Vin

9 : OUTPUT SIGNAL
Vout

**2-1** FIRST ANALOG SIGNAL PROCESSING ELEMENT CIRCUIT

**2-m** m-TH ANALOG SIGNAL PROCESSING ELEMENT CIRCUIT

**2-(m+1)** (m+1)-TH ANALOG SIGNAL PROCESSING ELEMENT CIRCUIT

**2-N** N-TH ANALOG SIGNAL PROCESSING ELEMENT CIRCUIT

**4** OFFSET DETECTING CIRCUIT

# FIG. 21

51:FIRST CONTROL CLOCK SIGNAL

52:SIGNAL OUTPUT

53:SECOND CONTROL CLOCK SIGNAL

54:OFFSET DETECTING CIRCUIT OUTPUT

55:THIRD CONTROL CLOCK SIGNAL

# FIG. 22

60:MAIN CONTROL CLOCK SIGNAL

MAIN CLOCK INPUT

57
SECOND CLOCK SIGNAL GENERATING CIRCUIT

58
SECOND CLOCK SIGNAL GENERATING CIRCUIT

51:FIRST CONTROL CLOCK SIGNAL

53:SECOND CONTROL CLOCK SIGNAL

SIGNAL INPUT

5

2
ANALOG SIGNAL PROCESSING CIRCUIT

SIGNAL OUTPUT

6

4
OFFSET DETECTING CIRCUIT

# FIG. 23

51:FIRST CONTROL CLOCK SIGNAL

53:SECOND CONTROL CLOCK SIGNAL

# FIG. 24

# FIG. 25

# FIG. 26

# FIG. 27

# FIG. 28

FIG. 29

FIG. 30